# EUROPEAN PATENT APPLICATION

(11) **EP 4 506 993 A1**
(43) Date of publication of application: **12.02.2025**
(21) Application number: 22939822.7
(22) Date of filing: 28.10.2022
(51) Int. Cl.: H01L 25/075, H01L 25/16, H01L 27/12, H01L 27/15

(54) **PIXEL UNIT FOR SEMICONDUCTOR DEVICE, METHOD FOR MANUFACTURING PIXEL UNIT, MICRO DISPLAY SCREEN AND DISCRETE DEVICE**

(30) Priority: 29.04.2022 CN 202210475669; 29.04.2022 CN 202210475676
(71) Applicant: Nuoshi Technology (Suzhou) Co., Ltd., Suzhou, Jiangsu 215000 (CN)
(72) Inventor: WANG, Yazhou, Suzhou, Jiangsu 215000 (CN)
(74) Representative: Winter, Brandl - Partnerschaft mbB
(86) International application number: PCT/CN2022/128283
(87) International publication number: WO 2023/207004

(57) **Abstract**

This application discloses a pixel unit for semiconductor device and a manufacturing method, a micro display screen, and a discrete device, the pixel unit includes a target drive circuit, a display unit, and a common cathode, the backplane is provided with a drive circuit, and the drive circuit is provided with at least one anode; the display unit is provided on the backplane, it includes a first device layer and a second device layer stacked vertically from bottom to top, the first device layer and the second device layer are respectively connected to the corresponding anodes of the backplane; the common cathode is respectively connected to each device layer in the display unit, and the common cathode is connected to the external cathode; the pixel unit provided by this application achieves multi-color display by stacking at least two device layers vertically on the backplane, compared with full-color pixel structure achieved by horizontal stacking, the pixel unit in this application occupies a small space in the horizontal direction, has a small loss in pixel density, and each vertically stacked layer in the display unit uses a common cathode to increase the area ratio of the luminous area.

## Description

### TECHNICAL FIELD

The present application relates to the technical field of semiconductor devices, and in particular to a pixel unit for semiconductor device and manufacturing method, a micro display screen, and a discrete device.

### BACKGROUND

Micro LED display technology refers to a display technology that uses selfluminous micron dimension LEDs as luminous pixel units and assembles them onto a drive panel to form a high-density LED array. Due to the characteristics of the micro LED chip such as small size, high integration and self-illumination, in terms of display, it has greater advantages than LCD and OLED in terms of brightness, resolution, contrast, energy consumption, service life, response speed and thermal stability. Micro LED applications will expand from flat-panel display to AR/VR/MR, spatial display, flexible transparent display, wearable/implantable optoelectronic devices, optical communication/optical interconnection, medical detection, smart car lights and many other fields. To this end, the technical personnel in the industry are constantly optimizing Micro LED display technology.

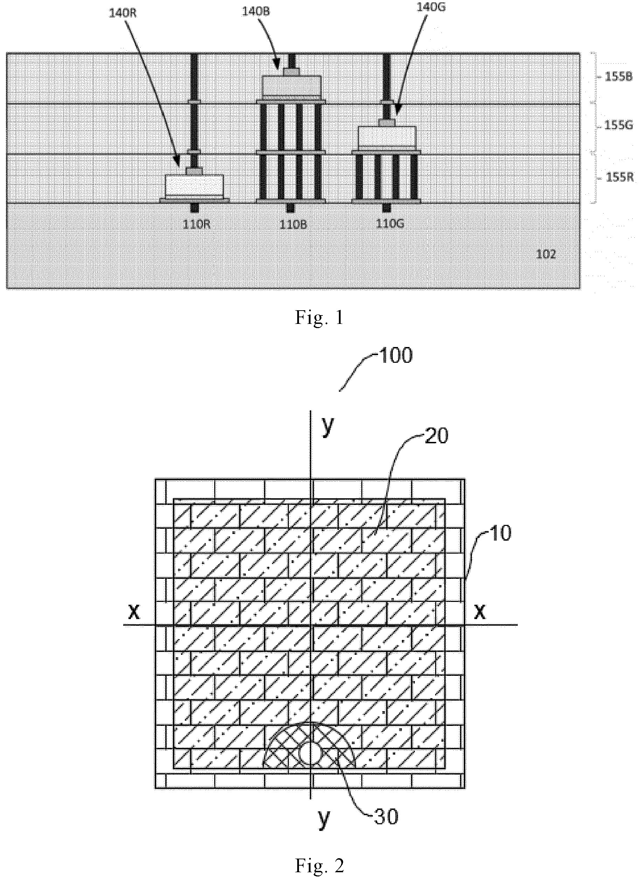

When Micro LED display technology is applied to the above fields, there is usually a requirement for full-color display. Published Chinese patent CN201880019435 discloses a method of manufacturing semiconductor device by stacking layers of micro LEDs, the semiconductor structure is shown in Fig. 1, which is a sectional view of several pixels of an integrated multi-color LED display panel. As can be seen from Fig. 1, the micro LED 140RGB are contained in different layers 155R, 155G, 155B stacked on top of the substrate and pixel driver. In one embodiment, the bottom layer 155R contains a red micro LED 140R, the middle layer 155G contains a green micro LED 140G, and the top layer 155B contains a blue micro LED 140B. Therefore, the patent is essentially a horizontally laid out RGB three-color scheme.

Those in the field should know that, in horizontally arranged pixel units, the proportion of the active area luminous body in the pixel area greatly limits the size of the luminous body, affects the luminous area, at the same time Micro-LED devices have a size effect: with the size decreases, the external quantum efficiency (EQE) drops sharply, especially when the diameter of the active area drops to 10um and below, the drop is extremely dramatic. Moreover, when the size of the active area is reduced, in circumstance of the same current density, the smaller the size of the active area, the lower the EQE. When the size of the active area is 20um and smaller, the EQE attenuation is more serious.

Therefore, the luminous area and external quantum efficiency of the pixel horizontal array arrangement or the essentially horizontal array arrangement stacking scheme used in the prior art are not very ideal.

Therefore, it is necessary to find a pixel unit that can achieve multi-color display and effectively increase the size ratio of the active area.

### SUMMARY

The purpose of this application is to provide a pixel unit and a manufacturing method for semiconductor device, a micro display screens and a discrete device, which can realize multi-color display with a large active area ration.

In order to achieve the above-mentioned application purpose, the first aspect of this application proposes a pixel unit for semiconductor device, the pixel unit includes:
a backplane;
a display unit, the display unit being provided on the backplane, the display unit including a first device layer and a second device layer that are vertically stacked in sequence, the second device layer being provided on a side surface of the first device layer away from the backplane, and the first device layer and the second device layer being respectively connected to the backplane;
a common cathode, the common cathode being connected to each device layer in the display unit respectively and an external cathode.

In a preferred embodiment, the common cathode includes a common cathode body, a first connection part and a second connection part respectively connected to the common cathode body, and the first connection part is connected to the first device layer, and the second connection part is connected to the second device layer.

In a preferred embodiment, the backplane is provided with a drive circuit, the drive circuit includes at least two anodes, any one of the anodes is connected to a corresponding device layer, the at least two anodes are located within the projection range of the display unit on the backplane;
the common cathode is connected to the external cathode.

In a preferred embodiment, the first device layer includes a first bonding layer, a first compound luminous layer and an insulation wrap layer arranged in sequence, the first compound luminous layer is attached to a surface of the first bonding layer away from the backplane, and the insulation wrap layer wraps the first bonding layer and the first compound luminous layer.

In a preferred embodiment, the first bonding layer is made of conductive material, and a first insulation layer is provided between the backplane and the first bonding layer;
the first insulation layer is provided with at least one first through hole, and the first bonding layer is connected to the corresponding first anode through the first through hole.

In a preferred embodiment, the common cathode is embedded inside the display unit; or,
the common cathode body is a metal frame surrounding the display unit in a circumferential direction, and the first connection part and the second connection part are embedded inside the display unit.

In a preferred embodiment, the first bonding layer is made of insulation material;
the first device layer further includes a first P-type ohmic contact layer provided between the first bonding layer and the first compound luminous layer, the first P-type ohmic contact layer includes a first P-type ohmic contact layer extension extending toward the common cathode but not contacting the common cathode;
the first device layer further includes a first electrical connection structure, one end of the first electrical connection structure is connected to the corresponding first anode, and the free end passes through the first bonding layer and is connected to the first P-type ohmic contact layer extension.

In a preferred embodiment, the common cathode body is a metal frame surrounding the display unit in a circumferential direction.

In a preferred embodiment, the first connection part is connected to the first compound luminous layer.

In a preferred embodiment, the first device layer further includes a first cathode ohmic contact layer, the first cathode ohmic contact layer is attached to a surface of the first compound luminous layer away from the first bonding layer, and the first connection part is connected to the first cathode ohmic contact layer.

In a preferred embodiment, the second device layer includes a second bonding layer, a second compound luminous layer and an insulation wrap layer; the second compound luminous layer is attached to a surface of the second bonding layer away from the first device layer, the insulation wrap layer wraps the first bonding layer and the first compound luminous layer.

In a preferred embodiment, the second bonding layer is made of transparent conductive material or transparent semiconductor material;
the second device layer also includes a second electrical connection structure, one end of the second electrical connection structure is connected to the second anode of the backplane, and the other end passes through the first device layer and is connected to the second bonding layer.

In a preferred embodiment, the second electrical connection structure includes a first metal pillar, one end of the first metal pillar is connected to the corresponding second anode, the other end passes through the first device layer and is connected to the second bonding layer; or,
the second electrical connection structure includes a first connection layer and a first metal pillar connected to the first connection layer, the first connection layer passes through the first insulation layer and is connected to the corresponding second anode, the first metal pillar is connected to the second bonding layer.

In a preferred embodiment, the second bonding layer is made of transparent insulation material;
the second device layer includes a second P-type ohmic contact layer provided between the second bonding layer and the second compound luminous layer, and the second P-type ohmic contact layer includes a second P-type ohmic contact layer extension extending toward the common cathode but not contacting the common cathode;
the second device layer further includes a third electrical connection structure, one end of the third electrical connection structure is connected to the corresponding third anode, and the free end passes through the first device layer and is connected to the second P-type ohmic layer extension.

In a preferred embodiment, the first compound luminous layer and the second compound luminous layer use the same compound luminous material, the first device layer and the second device layer are connected to the same anode, and the first device layer and the second device layer are arranged in series or parallel.

In a preferred embodiment, the display unit further includes a third device layer stacked on a side of the second device layer away from the first device layer;
the third device layer is connected to the third anode of the backplane;
the common cathode further includes a third connection part connected to the common cathode body, the third connection portion is connected to the third device layer.

In a preferred embodiment, the thickness of the common cathode decreases from one end close to the backplane to the other end.

In a preferred embodiment, the pixel unit further comprises an optical enhancement structure, the optical enhancement structure is stacked on a side of the display unit away from the backplane.

In a preferred embodiment, the backplane is provided with N anode pads and one cathode pad, part of the anode pads and part of the cathode pads are respectively embedded in the backplane, N≥1; any one of the anode pads is connected to a corresponding device layer, the cathode pad is connected to each device layer through the common cathode.

In a preferred embodiment, the display unit is provided separately from the backplane, and the at least two pads are provided separately from the backplane;
the pixel unit further includes a self-supporting structure, the self-supporting structure covers the device body and part of the backplane.

In a preferred embodiment, the self-supporting structure includes a covering part and a fixing part connected in sequence, the covering part covers the display unit, the fixing part is overlaid on the substrate; or,
the self-supporting structure includes a covering part, a second connection part and a fixing part connected in sequence, the covering part covers the display unit body, the fixing part is overlaid on the substrate, the connection part is provided separately from the substrate.

In the second aspect, providing a method of manufacturing a pixel unit for semiconductor device, the manufacturing method includes:
preparing a backplane, wherein the backplane is provided with a drive circuit, and the drive circuit is provided with at least one anode;
forming a display unit and a corresponding common cathode, bonding the pre-prepared first compound semiconductor to the backplane, constructing a first device layer and a first common cathode on at least one side corresponding to the first device layer; bonding the pre-prepared second compound semiconductor to the surface of the side of the first device layer away from the backplane, and constructing a second device layer and a second common cathode on at least one side of the second device layer in the circumferential direction of the second device layer, connecting the second device layer to the corresponding anode and the second common cathode of the backplane respectively, and the second common cathode and the first common cathode are connected end to end to form a common cathode.

In a preferred embodiment, a conductive material is used when bonding the first compound semiconductor to the backplane, wherein bonding the pre-prepared first compound semiconductor to the backplane includes:
plating insulation material on the entire surface of the backplane provided with at least two anodes, and opening at least two first through holes corresponding to the at least two anodes;
plating conductive material on the entire surface of the backplane after plating the insulation layer to form a backplane plated with bonding material;
plating conductive material on the entire surface of the first compound semiconductor to form a first compound semiconductor plated with bonding material;
bonding the backplane and the first compound semiconductor plated with bonding material, respectively;
removing the substrate of the first compound semiconductor.

In a preferred embodiment, constructing the first device layer and the first common cathode provided on at least one side of the first device layer in the circumferential direction, includes:
performing pattern exposure and etching on the first compound semiconductor to construct a first device layer corresponding to the backplane pattern and reserving at least one first through hole corresponding to the remaining anode;
providing a first cathode ohmic contact layer on a surface of the first device layer away from the first bonding layer;
using a semiconductor patterned coating to construct at least one metal pillar for subsequent device layers except to the first device layer in the at least one first through hole;
performing entire surface wrap passivation on the first compound semiconductor;
using a semiconductor patterned etching process to pattern and etch the first compound semiconductor after the entire surface passivation by silicon oxide to form electrical through holes corresponding to the remaining anode and the first cathode ohmic contact layer;
filling the formed electrical through holes to form electrical connections to the remaining anodes and to form a first common cathode.

In a preferred embodiment, an insulation material is used to bond the first compound semiconductor to the backplane to form a first bonding layer, wherein bonding the pre-prepared first compound semiconductor to the backplane, includes:
plating insulation material on the entire surface of the backplane;
forming a first P-type ohmic contact layer on the surface of the first compound semiconductor, and plating insulation material on the entire surface of the first P-type ohmic contact layer;
bonding the backplane to the first compound semiconductor;
removing the substrate of the first compound semiconductor.

In a preferred embodiment, constructing the first device layer and the first common cathode provided on at least one side of the first device layer in the circumferential direction, includes:
constructing the first device layer corresponding to the backplane pattern through patterned etching and exposing the corresponding first P-type ohmic contact layer extension;
using patterned etching to construct at least one second through hole corresponding to at least one of the anodes in the first P-type ohmic contact layer extension;
performing entire surface wrap passivation on the first compound semiconductor;
using a semiconductor patterned etching process to pattern and etch the first compound semiconductor after the entire surface passivation by silicon oxide to form an electrical channel corresponding to each anode and an electrical through hole corresponding to the first cathode ohmic contact layer;
filling the formed electrical through hole to form a first electrical connection structure corresponding to the first compound luminous layer , a partial electrical connection structure corresponding to the second compound luminous layer, and a first common cathode corresponding to the first compound luminous layer.

In a preferred embodiment, after completing the second device layer and the second common cathode provided on at least one side of the second device layer in the circumferential direction, forming the display unit and the common cathode further includes:
bonding a pre-prepared third compound semiconductor to the surface of the second device layer away from the first device layer, and constructing a third device layer and a third common cathode disposed on at least one side of the third device layer in the circumferential direction.

In the third aspect, providing a method of manufacturing a pixel unit for semiconductor device, the manufacturing method includes:
constructing at least two pads partially embedded in a pre-prepared backplane, the at least two pads include N anode pads and one cathode pad, N≥1;
sequentially stacking a first device layer and a second device layer on one side of the backplane where the at least two pads are inserted in a direction away from the backplane to form a display unit, wherein the first device layer and the second device layer are connected to the corresponding anode pad, respectively, and the first device layer and the second device layer is connected to the cathode pad through the formed common cathode.

In a preferred embodiment, before inserting at least two pads on the pre-prepared backplane, the method further includes:
etching to form at least two cavities corresponding to at least two pads on the pre-prepared backplane;
plating a sacrificial layer on the backplane with at least two cavities.

In a preferred embodiment, after sequentially stacking a first device layer and a second device layer on one side of the backplane where the at least two pads are inserted in a direction away from the backplane to form a display unit, the method further includes:
plating a dielectric material on the surface of the display unit and extending to part of the surface of the backplane to form a self-supporting structure;
etching the sacrificial layer on one surface of the backplane that is not plated with the dielectric material to separate the at least two pads from the backplane; wherein the ratio of the etching rate of the sacrificial layer to the backplane is greater than 10:1, and the ratio of the etching rate of the sacrificial layer to the self-supporting structure is greater than 10:1.

In the fourth aspect, providing a micro display screen, the micro display screen includes:
a micro display screen backplane, the micro display screen backplane including at least two drive circuits, input interfaces and output interfaces;
a display area, the display area being provided on the micro display screen backplane, and the display area including at least two display units included in the pixel unit for semiconductor device according to any one of the first aspect or the pixel unit manufactured by the manufacturing method according to any one of the second aspect;
a peripheral common cathode, the peripheral common cathode being electrically connected to the common cathode of each display unit respectively.

In the fifth aspect, providing a discrete device, the discrete device includes:
a discrete device backplane, the discrete device backplane including at least two anode pads and at least one cathode pad;
a device body, the device body being provided on the discrete device backplane, and the device body includes at least two display units included in the pixel unit for semiconductor device according to any one of the first aspect or the pixel unit manufactured by the manufacturing method according to any one of the third aspect.

Compared with the prior art, this application has the following beneficial effects:
This application provides a pixel unit and a manufacturing method for semiconductor device, a micro display screen, and a discrete device, the pixel unit includes a backplane; a display unit, which is provided on the backplane, and includes a first device layer and a second device layer stacked vertically from bottom to top, wherein the second device layer is provided on a surface of the first device layer away from the backplane, and the first device layer and the second device layer are respectively connected to the backplane; a common cathode, which is connected to each device layer in the display unit; the pixel unit provided in this application achieves multi-color display by stacking at least two device layers vertically on the backplane, compared with horizontal stacking to achieve a full-color pixel structure, in this application, the space occupied by the pixel unit in the horizontal direction is smaller, and the loss of pixel density is smaller; further, the vertically stacked layers of the display unit in this application use a common cathode, which can reduce the area ratio of the cathode in the display unit, increase the area ratio of the luminous area, reduce the impact of size effects, and at the same time increase the stacking number of device layers in the vertical direction or form redundant circuits;
Furthermore, the common cathode body is a metal frame surrounding the display unit in the circumference direction; in this application, by setting the metal frame, not only the common cathode of each device layer inside the pixel is realized, but the metal frame also realizes the connection of all pixels to the cathode, that is, the common cathode of all pixels, at the same time, the metal fence can be used as pixel isolation, which can prevent optical crosstalk between pixels, and has the function of a side wall reflector;
Furthermore, the thickness of the common cathode decreases from one end close to the backplane to the other end, forming an inverted bowl-shaped peripheral cathode as a constrained side wall reflection structure;
Furthermore, the pixel discrete device of this application is connected to an external circuit based on at least two pads, when packaging the discrete device to the target backplane for electrical connection, metal welding such as eutectic may be avoided to avoid performance impact on the discrete device itself and simplify the process;
Furthermore, the display unit in this application is provided separately from the backplane, and at least two pads are provided separately from the backplane; the pixel unit further includes a self-supporting structure, and the self-supporting structure covers the display unit and part of the backplane, by providing a self-supporting structure, the pixel unit achieves structural stability under the setting that the display unit is separated from the backplane and is convenient for later use, more importantly, the backplane under this structure can be recycled, thereby reducing costs;
Furthermore, the self-supporting structure includes a covering part, a second connection part and a fixing part connected in sequence, the covering part covers the display unit, the fixing part is overlaid on the substrate, and the second connecting part is separated from the substrate, the self-supporting structure under this structure ensures the fixation effect of the self-supporting structure on the device layer, and improves the operational convenience when the covering part and the fixing part break under the action of external force during transfer, more importantly, the breaking position is located at the second connection part instead of the covering part or the fixing part to avoid damaging the substrate or device layer;
Furthermore, in the method of manufacturing a pixel unit for semiconductor device provided by this application, in the process of stacking the device layers, the metal pillars are first constructed, then passivated, and then the passivation layer is etched to construct electrical through holes and then filled in the electrical through holes to form electrical connections, compared with the existing solution of etching the metal layer to construct electrical connections, this solution reduces the difficulty of constructing electrical connections in the stacking solution, especially improves the feasibility of metals (such as copper) that are difficult to dry-etch as electrical connection structures.

### BRIEF DESCRIPTION OF THE DRAWINGS

Fig. 1 is a schematic structural diagram of a semiconductor device involved in the background art;
Fig. 2 is a top view of the pixel unit in Embodiment 1;
Fig. 3 is a sectional view of the x-x section in Fig. 2;
Fig. 4 is a sectional view of the y-y section in Fig. 2;
Fig. 5 is a schematic diagram of an exemplary circuit structure of the backplane in Embodiment 1;
Fig. 6 is a schematic diagram of the circuit structure of any device layer;
Fig. 7 is a schematic diagram of a circuit structure in which at least two device layers of the same compound luminous layer material are arranged in parallel;
Fig. 8 is a schematic diagram of a circuit structure in which at least two device layers of the same compound luminous layer material are arranged in series;
Fig. 9 is a schematic structural diagram of a pixel unit with an optical enhancement structure in Embodiment 1;
Fig. 10 is a backplane plated with bonding material in Embodiment 1;
Fig. 11 is a top view after constructing the first device layer in Embodiment 1;
Figs. 12 and 13 are sectional views of the x-x and y-y sections in Fig. 6 respectively.
Figs. 14 to 16 are sectional views of the x-x section of Fig. 11 and the y-y section of Fig. 11 after constructing the electrical connection channel in Embodiment 1;
Figs. 17 and 18 are respectively sectional views of x-x and y-y sections after completing the electrical connection of the first device layer in Embodiment 1;
Fig. 19 is the visible light transmittance data using silicon as the bonding material in Embodiment 1;
Figs. 20 and 21 are sectional views of the x-x and y-y sections in Embodiment 2;
Fig. 22 is a sectional view of the bowl-shaped common cathode of the pixel unit in Embodiment 2;
Figs. 23 and 24 are a top view of the pixel unit and a sectional view of the y₃-y₃ section in Embodiment 3;
Figs. 25 and 26 are respectively sectional views of the first layer stacking and the second layer stacking in Embodiment 3;
Figs. 27 is a schematic three-dimensional structural diagram of the micro display screen in Embodiment 4;
Fig. 28 is a top view of a pixel-level discrete device in Embodiment 5;
Fig. 29 is a sectional view of the pixel-level discrete device (including two device layers) in the A-A direction in Fig. 28;
Fig. 30 is a sectional view of the pixel-level discrete device (including three device layers) in the A-A direction in Fig. 28;
Fig. 31 is a sectional view of the pixel-level discrete device (including three device layers) in the B-B direction in Fig 28;
Fig 32 is a top view of the backplane and at least one pad in Embodiment 5;
Fig. 33 is a sectional view along the B-B direction in Fig. 32 (solid pad);
Fig. 34 is a sectional view along the B-B direction in Fig. 32 (hollow pad);
Fig. 35 is a sectional view of the pixel-level discrete device (including two device layers) in the A-A direction in Embodiment 6;
Fig. 36 is a sectional view of the pixel-level discrete device (including two device layers) in the B-B direction in Embodiment 6;
Fig. 37 is a sectional view of the pixel-level discrete device (including three device layers) in the B-B direction in Embodiment 6;
Fig. 38 is a sectional view of the pixel-level discrete device (including three device layers) in the B-B direction in Embodiment 6.

### Reference signs:

100-pixel unit, 10-backplane, 13-first anode, 14-second anode, 15-third anode, 20-display unit, 21-first device layer, 211-first bonding layer, 212- first compound luminous layer, 214-first insulation layer, 215-first cathode ohmic contact layer, 216-first P-type ohmic contact layer, 2161-first P-type ohmic contact layer extension, 22-second device layer, 221-second bonding layer, 222-second compound luminous layer, 223-second cathode ohmic contact layer, 224-second P-type ohmic contact layer, 2241-second P-type ohmic contact layer extension. 23-third device layer, 231-third bonding layer, 232-third compound luminous layer, 233-third cathode ohmic contact layer, 234-third P-type ohmic contact layer, 24-insulation wrap layer, 25-second electrical connection structure, 251-first metal pillar, 252-first connection layer, 26-fourth electrical connection structure; 27-first electrical connection structure, 28-third electrical connection structure, 29-fifth electrical connection structure, 30-common cathode, 31-common cathode body, 32-first connection part, 33-second connection part, 34-third connection part, first common cathode 35, second common cathode 36, third common cathode 37, 40-optically enhanced structure, 200-micro display screen, 300-micro display screen backplane, 400-display area, 500-peripheral common cathode, 600-external IO interface; 100'-pixel-level discrete device, 10'-backplane, 20'-device body, 21'-first device layer, 211'-first bonding layer, 212'-first compound luminous layer, 2121'-first P-type ohmic contact layer, 213'-first insulation wrap layer, 214'-first electrical connection structure, 22 -second device layer, 221'-second bonding layer, 222'-second compound luminous layer, 2221 -second P-type ohmic contact layer, 223'-second insulation wrap layer, 224 -second electrical connection structure, 23'-third device layer, 30'-common cathode, 31'-first common cathode part, 32 -second common cathode part, 33'-third common cathode part, 41'-cathode pad, 411'-first connection part, 412'-needle part, 42'-first anode pad, 43'-second anode pad, 44'-third anode pad, 50'-self-supporting structure, 51'-covering part, 52'-fixing part, 53'-second connection part.

### DETAILED DESCRIPTION OF THE APPLICATION

In order to make the purpose, technical solutions and advantages of the present application clearer, the technical solutions in the embodiments of the present application will be clearly and completely described below in conjunction with the accompanying drawings in the embodiments of the present application, obviously, the described embodiments are only some of the embodiments of this application, but not all of the embodiments. Based on the embodiments in this application, all other embodiments obtained by those of ordinary skill in the art without creative efforts fall within the scope of protection of this application.

In the description of this application, it should be understood that the orientation or positional relationship indicated by the terms "on", "below", "in", "out", etc. is based on the orientation or positional relationship shown in the drawings, it is merely to facilitate the description and simplify the description and is not intended to indicate or imply that the device or element referred to must have a specific orientation, be constructed and operate in a specific orientation, therefore should not be construed as a limitation of the present application. In addition, the terms "first" and "second" are used for descriptive purposes only, and cannot be understood as indicating or implying relative importance or implicitly indicating the quantity of indicated technical features. Therefore, features defined as "first" and "second" may explicitly or implicitly include one or more of these features. In the description of this application, unless otherwise stated, "plurality" means two or more.

In the description of this application, it should be noted that, unless otherwise clearly stated and defined, the terms "install", "link" and "connect" should be understood in a broad sense, for example, it may be a fixed connection, a detachable connection, or an integral connection; it may be a mechanical connection, or it may be an electrical connection; it may be a direct connection, or it may be an indirect connection through an intermediate medium, or it may be the internal connection between two components. For those of ordinary skill in the art, the specific meanings of the above terms in this application can be understood on a case-by-case basis.

As mentioned in the background art, existing Micro-LED semiconductor devices usually use horizontal stacking to achieve full-color. However, horizontal stacking brings problems such as large space occupied in the horizontal direction and a small proportion of luminous area, which seriously affects the development of small-size devices. To this end, this embodiment provides a pixel unit for semiconductor device and a manufacturing method, and a micro display screen, which can effectively solve the above problems.

### Embodiment 1

As shown in Figs. 2 to 4, this embodiment provides a pixel unit 100 for semiconductor device, and the pixel unit includes a backplane 10, a display unit 20 and a common cathode 30. The pixel unit 100 is used in semiconductor devices such as micro display screens and invisible light detectors.

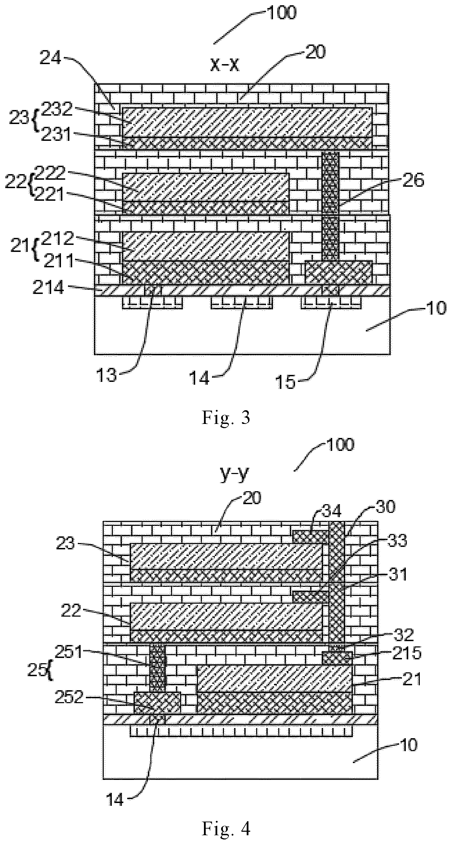

Note: Figs. 3 and 4 are two perpendicular sectional views in Fig. 2 (top view), the subsequent structural drawings are also top views or corresponding sectional views under the current structure, the x-x section involved is the horizontal section in the top view, the y-y section is the vertical section in the top view.

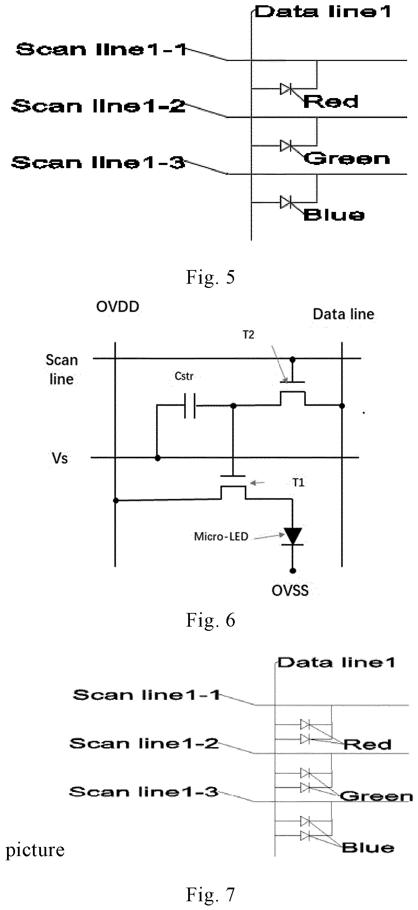

Wherein, the backplane 10 is provided with a drive circuit, the drive circuit is provided with at least one anode, for example, a circuit diagram of the driving circuit is shown in Fig. 5. It should be noted that the circuit diagram in this embodiment is a simple schematic diagram, and all are active drives. The circuit inside the pixel unit may include active, passive or semipassive control circuits. For example, Fig. 6 below is a circuit diagram of any device layer. The display unit 20 is deposited on the backplane 10, and the display unit 20 includes a first device layer 21 and a second device layer 22 stacked vertically from bottom to top, the first device layer 21 and the second device layer 22 are respectively connected to the corresponding anode of the backplane 10. Therefore, the pixel unit 100 provided in this embodiment is a vertical stack pixel (hereinafter referred to as VSP). The common cathode 30 is embedded in the display unit 20, and the common cathode 30 is connected to each device layer in the display unit 20 respectively, the common cathode 30 is connected to the external cathode. Preferably, the common cathode 30 in this embodiment is one of a columnar structure or a plate structure.

Of course, the number of device layers stacked in the vertical direction in this embodiment includes but is not limited to two layers, it may be three layers, four layers or even more, and the compound luminous layer materials used in all device layers may be the same or different. When each device layer uses different compound luminous layers, multi-color display such as full-color display may be achieved; when two or more device layers use the same compound luminous layer, the light intensity may be enhanced or a redundant structure may be formed, of course, the two solutions may coexist in the same display unit 20, and this embodiment does not limit this.

For ease of description, in this embodiment, the display unit 20 includes a first device layer 21, a second device layer 22, and a third device layer 23, and the first device layer 21 emits red light (R), the second device layer 22 emits green light (G), the third device layer 23 emits blue light (B), that is, full-color pixels of R, G, B are realized. For example, the first device layer 21 is epitaxially grown using a red light InGaN compound, the second device layer 22 is epitaxially grown using a green light InGaN compound, the third device layer 23 is epitaxially grown using a blue light InGaN compound.

Specifically, the backplane 10 may be one of a film transistor (TFT), a low-temperature polysilicon (LTPS), a CMOS integrated circuit, and a high electron mobility transistor (HEMT), for the convenience of description, this embodiment takes a CMOS integrated circuit as an example for further elaboration, but it is not limited to this. Furthermore, the at least two anodes (anode through holes) included in the backplane 10 are evenly arranged, and the at least two anodes are located within the projection range of the display unit 20 on the backplane 10. At least two anodes are evenly arranged, in the embodiment of three device layers, possible arrangement manners include being distributed on the same straight line or in a triangle shape, etc., the anodes of preset number may be provided on the edge, corner, middle or center of the backplane 10. This embodiment does not limit the number of anode through holes provided on the backplane 10, and by increasing the number of anode through holes, more layers of VSP stacking or redundant circuits may be formed. It should be noted that a cathode (cathode through hole) may be provided on the backplane 10 to connect the common cathode 30 to the drive circuit.

Furthermore, the backplane 10 includes at least one top metal, the top metal covers at least one anode. Of course, the backplane 10 may not be provided with a top metal, which is not limited in this embodiment.

Alternatively, the backplane 10 includes in-situ reflectors disposed on its upper surface, the in-situ reflectors correspond one to one and cover or expose at least one anode. The in-situ reflector may be made of metal, such as aluminum, gold, silver, etc.; it may also be a Bragg reflective layer, the Bragg reflective layer is formed by stacking two or more films with different refractive indexes, such as a stack of silicon oxide and titanium oxide, silicon oxide and aluminum oxide, silicon oxide and silicon nitride, etc.; it may also be an ODR total reflection mirror stacked with metal and dielectric, such as at least one combination of silver and silicon oxide, aluminum and aluminum oxide, gold and silicon oxide, etc., for example, a stack of metallic aluminum 250nm and silicon oxide 150nm (target wavelength 620nm, 1/4 is 150nm) has better reflectivity in part of visible light wavelength range.

The in-situ reflector may be a polygonal structure such as a circle, triangle, quadrilateral, pentagon, hexagon, or octagon, or a combined polygon that avoids contact points, the polygon may be inscribed in the pixel boundary, or it may also be retracted by a certain length from the boundary.

As further shown in Figs. 2 to 4, the common cathode 30 in this embodiment includes a common cathode body 31, a first connection part 32, a second connection part 33 and a third connection part 34 respectively connected to the common cathode body 31. The first The connection part 32 is connected to the first device layer 21, the second connection part 33 is connected to the second device layer 22, the third connection part 33 is connected to the third device layer 23.

Specifically, the first device layer 21 includes a first bonding layer 211, a first compound luminous layer 212 and an insulation wrap layer 24 which are arranged sequentially from bottom to top, the first compound luminous layer 212 is attached to the surface of the first bonding layer 211 on the side away from the backplane 10, the insulation wrap layer 24 wraps the first bonding layer 211 and the first compound luminous layer 212.

Preferably, the insulation wrap layer 24 may be an inorganic dielectric material such as silicon oxide, silicon nitride, or aluminum oxide, or it may be an organic dielectric material such as SU8 or polyimide, which is not limited in this embodiment.

The first bonding layer 211 is made of conductive material or insulation material, in this embodiment, the first bonding layer 211 is made of conductive material. A first insulation layer 214 is provided between the backplane 10 and the first bonding layer 211, the first insulation layer 214 is provided with at least one first through hole, the first bonding layer 214 is connected to the corresponding first anode 13 through the first through hole to avoid short circuit at the bottom of the pixel stack. The conductive material used in the first bonding layer 211 may be compound materials such as ITO, ZnO, GaP, GaAs, GaN, and the like, or metal materials such as Au, Al, Cu, and the like, or semiconductor materials such as Si, and the like, or organic dielectric material such as SUB and BCB. In addition, the first bonding layer 211 does not have light transmission requirements, so it may be made of transparent or opaque conductive materials, and there is no limitation here. The first insulation layer 211 used may be a SiO₂ film, and the thickness of SiO₂ film is 100±5 nm.

On this basis, the first compound luminous layer 212 is obtained by bonding the first compound semiconductor to the backplane 10 and removing the substrate.

In this embodiment, the first compound semiconductor forms a P-type ohmic contact on the P contact surface, the P-type ohmic contact material may be a transparent conductive material such as ITO and the like, or a stack or alloy of metal materials such as Au, Zn, Be, and the like. The P contact surface is ITO coated by evaporation, sputtering, etc., and as a preferred option, the thickness of ITO film is 500nm, and ohmic contact is formed by high temperature annealing at 500°C in N₂ atmosphere. Of course, the thickness of the contact layer of P contact coating film on the surface of the compound and the conditions for forming contact may be adjusted and changed according to needs.

For example, if the substrate is N-GaAs and the red light is AlGaInP system, the structure is shown in Table 1 below:

**Table 1**

| Layer name | Material |
|---|---|
| P contact | P-GaAs |
| MQW | AlGaInP |
| N contact | N-AlGaInP |
| Etch Stop | N-AlGaInP |
| Substrate | N-GaAs |

If it is an InGaN system, the structural diagram may be shown in Table 2 or Table 3 below, and these two may be used as blue light, green light and other wavelength compound structures at the same time.

**Table 2**

| Layer name | Material |
|---|---|
| P contact | P-GaAs |
| MQW | InGaN&GaN |
| N contact | GaN |
| Etch Stop | AlN&GaN |
| Substrate | Si |

**Table 3**

| Layer name | Material |
|---|---|
| P contact | P-GaN |
| MQW | InGaN&GaN |
| N contact | GaN |
| Etch Stop | InGaN |
| Substrate | GaN |

Furthermore, the first connection part 32 is connected to the first compound luminous layer 212. In a preferred embodiment, the first device layer 21 further includes a first cathode ohmic contact layer 215, the first cathode ohmic contact layer 215 is attached to the surface of the first compound luminous layer 212 away from the first bonding layer 211, the first connection part 32 is connected to the first cathode ohmic contact layer 215, and is electrically connected to the first compound luminous layer 212 through the first cathode ohmic contact layer 215. Furthermore, the first connection part 32 in this embodiment is arranged vertically.

As shown in Fig. 4, the common cathode 30 in this embodiment is arranged vertically upward from the surface of the first compound luminous layer 212, and the subsequent second connection part 33 and the third connection part 34 are arranged horizontally.

Continuing to refer to Figs. 3 and 4, the second device layer 22 includes a second bonding layer 221, a second compound luminous layer 222 and an insulation wrap layer 24; the second compound luminous layer 222 is attached to the surface of the second bonding layer 221 away from the first device layer 21, the insulation wrap layer 24 wraps the second bonding layer 221 and the second compound luminous layer 222.

The second bonding layer 221 may be made of conductive material or insulation material, but in order to transmit the red light of the first device layer 21, the second bonding layer 221 should be made of transparent material. For example, the second bonding layer 221 in this embodiment is made of transparent conductive material or transparent semiconductor material.

On this basis, the second device layer 22 further includes a second electrical connection structure 25 for electrically connecting with the corresponding second anode 14 on the backplane 10, one end of the second electrical connection structure 25 is connected to the corresponding exposed second anode 14 on the backplane 10, the other end is connected to the second bonding layer 221 through the first device layer 22.

Furthermore, the second electrical connection structure 25 may be implemented in various ways. In one implementation, the second electrical connection structure 25 includes a first metal pillar 251, one end of the first metal pillar 251 is connected to the corresponding second anode 14, and the other end passes through the first device layer 21 and is connected to the second bonding layer 221. In another implementation, the second electrical connection structure 25 includes a first connection layer 252 and a first metal pillar 251 connected to the first connection layer 252, the first connection layer 252 passes through the first insulation layer 214 and is connected to the corresponding second anode 14, the first metal pillar 251 is connected to the second bonding layer 221. The first connection layer 252 may be formed by the bonding material covering the second anode 14 left when constructing the device by using etching, or it may also be formed in advance through a semiconductor patterned coating process after the device structure is formed by etching to form the exposed second anode 14 through hole.

As mentioned above, when the first compound luminous layer 212 and the second compound luminous layer 222 use the same compound luminous material, the first device layer 21 and the second device layer 22 are connected to the same anode, and the first device layer 21 and the second device layer 22 are arranged in series or parallel. It can be seen that when N (N≥2) layers of compound VSP are stacked, and when at least two device layers use the same compound luminescent material, the two device layers are used as redundant structures in the vertical direction, which can achieve performance enhancement and be used as redundancy to guarantee the pixel yield, and the at least two device layers adopt common anode and common cathode electrical connections within the pixel.

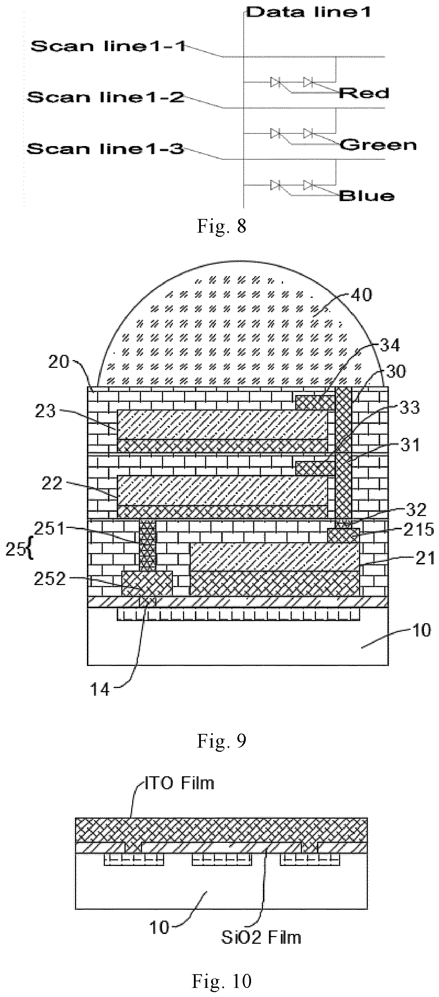

For example, in a pixel unit for full-color micro display screen, when two device layers of the same compound luminous layer are connected in parallel, the drive circuit is as shown in Fig. 7, when two device layers of the same compound luminous layer are connected in series, the drive circuit is as shown in Fig. 8.

It should be noted that in this embodiment, the second electrical connection structure 25 and the first device layer 21 are in a non-contact state, so there is a certain overlap and offset portion in the projection of the first device layer 21 and the second device layer 22 on the backplane 10, the offset portion is used for the arrangement of the second electrical connection structure 25 and the common cathode 30 in the vertical direction.

In a preferred embodiment, the second device layer 22 further includes a second cathode ohmic contact layer, and the second cathode ohmic contact layer is attached to a surface of the second compound luminous layer 222 away from the second bonding layer 221, the second connection part 33 is connected to the second cathode ohmic contact layer. Further preferably, the second connection part 33 is arranged horizontally.

Similar to the first device layer 21, under the premise of setting the second compound luminous layer 222, the material of the insulation wrap layer 24 of the second device layer 22 is consistent with that of the insulation wrap layer 24 of the first device layer 21, which will not be described in detail in this embodiment.

Similar to the first device layer 21 and the second device layer 22, the third device layer 23 is stacked on a side of the second device layer 22 away from the first device layer 21. The third device layer 23 is connected to the third anode of the backplane 10, the common cathode 30 further includes a third connection part 34 connected to the common cathode body 31, the third connection part 34 is connected to the third device layer 23.

Specifically, the third device layer 23 also includes a third bonding layer 231, a third compound luminous layer 232, an insulation wrap layer 24, a fourth electrical connection structure 26 and a third cathode ohmic contact layer. In addition, the third bonding layer 231 is made of transparent conductive material (such as ITO), one end of the fourth electrical connection structure 26 is connected to the third bonding layer 231, and the other end passes through the first device layer 21 and the second device layer 22 and is connected to the third anode 15 of the backplane 10. Preferably, the third connection part 34 included in the common cathode 30 is connected to the common cathode body 31 through the third cathode ohmic contact layer 233, thereby realizing the common cathode 30 of the first device layer 21, the second device layer 22 and the third device layer 23.

It can be understood that the fourth electrical connection structure 26 in this embodiment is in a non-contact state with the first device layer 21 and the second device layer 22, so there are certain overlap and offset portions in the projections of the third device layer 23, the second device layer 22 and the first device layer 22 on the backplane 10, respectively, the offset portion is used for the arrangement of the third cathode ohmic contact layer 25, the fourth electrical connection structure 26 and the common cathode 30 in the vertical direction, and the area of the offset portion is relatively small.

Therefore, the common cathode 30 in this embodiment is embedded in the display unit 20, in order to realize the common cathode 30 between the adjacent pixel units 100, a conductive film is provided on the top layer of the display unit 20. By connecting the external cathode common electrode of the conductive film between adjacent pixel units 100, the area ratio of the cathode in the display unit 20 may be reduced and the area ratio of the luminous area may be increased.

Preferably, the pixel unit 100 further includes an optical enhancement structure 40, the optical enhancement structure 40 is stacked on a side of the pixel unit 100 away from the backplane 10. Specifically, as shown in Fig. 9, after stacking multiple device layers through VSP, optical enhancement structures 40, such as polarizers, lenses, etc., are stacked through VSP, the lenses may be organic materials, such as SU8, polyimide, etc., and may be inorganic materials, such as silicon oxide, alumina, etc.

Therefore, the pixel unit for semiconductor device provided in this embodiment achieves multi-color display by stacking at least two device layers vertically on the backplane, compared with horizontal stacking to achieve a full-color pixel structure, the pixel unit in this application occupies less space in the horizontal direction and suffers less loss in pixel density; further, the vertically stacked layers of the display unit in this application use a common cathode to reduce the area ratio of the cathode in the display unit, increase the area ratio of the luminous area, reduce the impact of size effects, and at the same time improve the number of stacked device layers in the vertical direction or form a redundant circuit.

Corresponding to the pixel unit for semiconductor device in this embodiment, this embodiment also provides a method for manufacturing a pixel unit for semiconductor device, the manufacturing method includes the following steps:
S1. Preparing the backplane 10, the backplane 10 is provided with a drive circuit, and the drive circuit is provided with at least one anode. Corresponding to the aforementioned pixel unit 100, the backplane 10 in this embodiment is a CMOS backplane.
S2. Making the display unit 20 and the corresponding common cathode 30, bonding the pre-prepared first compound semiconductor to the backplane 10, and constructing the first device layer 21 and the first common cathode 31 corresponding to the first device layer 21; bonding the pre-prepared second compound semiconductor to the surface of the first device layer 21 away from the backplane 10, and constructing the second device layer 22 and the corresponding second common cathode 35, connecting the second device layer 22 to the corresponding anode and the second common cathode 35 of the backplane 10 respectively, the second common cathode 35 and the first common cathode 34 are connected end to end to form a common cathode 30, the common cathode 30 is connected to the external cathode.

In this embodiment, the first compound semiconductor is bonded to the backplane 10 to form a first bonding layer using a conductive material, such as ITO. The compound semiconductor is usually a wafer or a suitably sized area cut from a wafer. Taking a wafer as an example, the compound wafer refers to a compound formed of two or more elements with a definite atomic ratio, and has semiconductor properties such as determined bandgap width and energy band structure. It includes crystalline inorganic compounds (such as III-V and II-VI compound semiconductors), organic compounds (such as organic semiconductors) and oxide semiconductors, etc., the substrate material may be GaAs, GaN, Si, SIC, Sapphire, etc., then layers that form electrical contacts are prepared on the surface of the compounds, and any combination may be used when VSP stacking the compounds later.

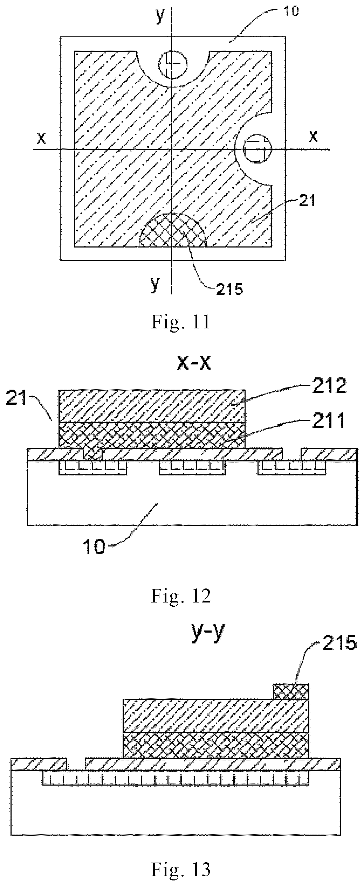

On this basis, the step S2 specifically includes:
S21. Plating an insulation material (such as SiO2) on the entire surface of the backplane 10 with at least two anodes to form a first insulation layer 214, and opening at least two first through holes corresponding to the at least two anodes.
S22. Plating a conductive material ITO on the entire surface of the backplane 10 after plating the insulation layer to form a backplane 10 plated with bonding material, the entire ITO coating film is 360±10 nm. Of course, before step S22, in a preferred embodiment, an in-situ reflector or a top metal corresponding to the anode through holes one by one may also be provided on the surface of the backplane 10. An exemplary implementation is to optimize the optoelectronic properties of ITO through high-temperature ITO annealing or heating during the coating process, and then flatten the uneven surface of ITO by the CMP process, in which the surface roughness is required to be in the range of 0.1~5nm, as shown in Fig. 10.
S23. Plating conductive material on the entire surface of the first compound semiconductor to form a first compound semiconductor plated with bonding material; specially, forming Ni (5nm) Au (10nm) stack on the entire P surface of the first compound semiconductor, and forming ohmic contact through high-temperature annealing to form a P contact layer, performing ITO coating on the surface of the P contact layer by evaporation, sputtering, etc., the ITO film thickness is 500±10nm. After that, annealing at high temperature at 500°C in N₂ environment to form ohmic contact to optimize the photoelectric properties of ITO, then flattening the uneven surface of ITO through chemical mechanical polishing (CMP) process, in which the surface roughness is required to be in the range of 0.1~5nm. Of course, the thickness of the P contact plating contact layer on the surface of the compound and the conditions for forming contact may be adjusted and changed according to requirements, and this embodiment does not limit this.
S24. Bonding the backplane 10 respectively plated with the bonding material to the first compound semiconductor.
S25. Removing the substrate of the first compound semiconductor to complete the bonding of the first compound semiconductor and the backplane 10, as shown in Figs. 11 to 13.

Specifically, in this embodiment, the ITO surface is treated through cleaning or surface activation. In one embodiment, the surface is activated by immersion in ammonia water after Ar plasma treatment, and then the backplane 10 is bonded to the first compound semiconductor, after bonding, the compound substrate is removed, the compound N contact is exposed by etching, the bonding may be non-aligned bonding or aligned bonding, when the target compound is a partial area cut from the wafer, the fan-out packaging type may be used for bonding. For example, when the first layer of compound semiconductor is an AlGaInP quaternary compound, after bonding, the substrate is removed with a mixture of ammonia and hydrogen peroxide, and the N contact layer is exposed by etching with hydrochloric acid.

After completing the construction of the first device layer 21 and the first common cathode 30 disposed on at least one side of the first device layer 21 in the circumferential direction, the process specifically includes: S26. Performing patterned exposing and etching on the first compound semiconductor to form a first device layer 21 corresponding to the pattern of the backplane 10 and reserve at least one first through hole corresponding to the remaining anode, in which the first device layer 21 includes a first bonding layer 211 and a first compound luminous layer 212.

S27. Providing the first cathode ohmic contact layer 215 on the surface of the first device layer 21 away from the first bonding layer. Specifically, the first cathode ohmic contact layer 215 may be a laminate or alloy material of metals such as Au, Ge, Ni, etc.

It should be noted that, when performing compound VSP stacking, the order of the above-mentioned steps S26 and S27 is not limited, i.e. the first device layer 21 may be constructed first or the first cathode ohmic contact layer 215 may be constructed first.

Specifically, as shown in Fig. 11, the lower semicircular filling area is the first cathode ohmic contact layer 215, the subsequent two layers of stacked anodes (the second anode 14 and the third anode 15) are exposed through a patterned etching process, and the anode may be exposed directly to the backplane 10 or conductive bonding material, for convenience of description, this embodiment takes the exposure of the anode to the backplane 10 as an example for further description.

S28. Using a semiconductor patterned coating to construct at least one first metal pillar 251 on at least one first through hole for subsequent device layers except the first device layer 21.

S29. Performing entire surface wrap passivation on the first compound luminous layer; the insulation material used for the wrap passivation may be inorganic dielectric materials such as silicon oxide, silicon nitride, and aluminum oxide, and the like, or organic dielectric materials such as SU8 , polyimide, and the like. For example, passivation is completed by spin coating of silicone such as SU8 and the like.

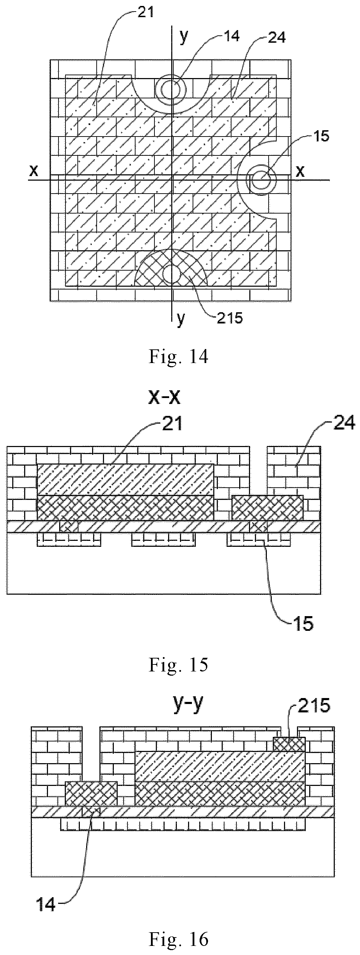

S210. Using a semiconductor patterned etching process to pattern and etch the first compound luminous layer 212 after silicon oxide passivation on the entire surface to form electrical through holes corresponding to the remaining anode and the first cathode ohmic contact layer 215; wherein the remaining anode is used as the anode for subsequent stacked layers (second anode 14, third anode 15). The details are shown in Figs. 14~16.

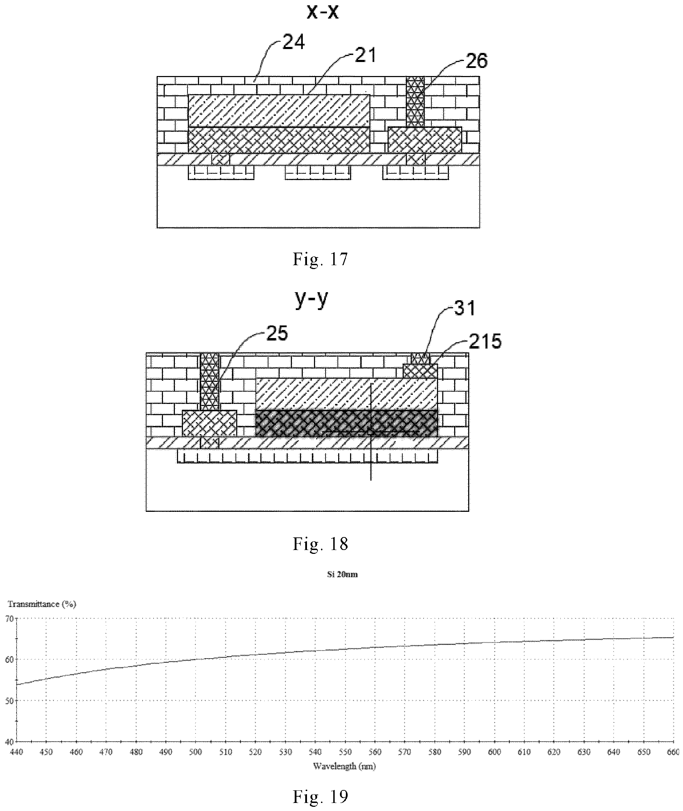

S211. Filling the formed electrical through holes to form electrical connections of the remaining anodes and form a first common cathode 34, the parts included in the first common cathode 35 are specifically shown in Figs. 17 and 18.

Step S211 specifically includes:
Using metal evaporation, sputtering, electroplating, electroless plating, etc. to fill the entire surface with a single layer, alloy or stack of metal Al, Ti, W, Au, Ni or Cu films, then using the CMP method to expose the metalwrapped silicon oxide to complete the filling of the electrical through holes of the first cathode ohmic contact layer 215 and the electrical connection of subsequent device layers (i.e., the second electrical connection structure 25 and the fourth electrical connection structure 26, etc. ).

It should be noted that the above-mentioned steps S28 to S211 draw lessons from the Damascus inlay process in the field of integrated circuits to construct the electrical connection structure, compared with the existing scheme of etching the metal layer to construct the electrical connection, the process difficulty of constructing electrical connections in stacking solutions is reduced, and especially, the feasibility of using metals (such as copper) that are difficult to dry-etch as electrical connection structures is improved.

After completing the construction of the first device layer 21 in step S211, continue to construct the second device layer 22 and the third device layer 23 in a similar manner, as shown in Figs. 2 to 4.

Specifically, the first layer of stack may choose opaque materials, such as Au, Cu, etc., but starting from the Nth (N≥2) layer of stack, the bonding film used needs to match the compound of the N-1 layer to ensure the wavelength of light emitted by the N-1 layer compound semiconductor can be transmitted, at the same time, the light of the N-1 layer compound may be filtered to select the light of a specific wavelength band to transmit; and the bonding material of the Nth layer may have optical enhancement functions on the Nth layer or N+1 layer, such as polarization, reflection, etc. The bonding layer of the Nth layer must be transparent and may be conductive, for example, compound material such as ITO, ZnO, GaP, GaAs, GaN and the like, or non-conductive, including single layers or stacks of dielectric materials such as SiO₂, Ti₂O₃, Si₃N₄, Al₂O₃, AlN, and the like, or organic materials such as SU8 and BCB, or materials that are light-transmissive at ultra-thin thickness, such as Ag, Si, etc., which have a certain transmittance when the thickness is within 20nm. In one embodiment, 20nm Si is used, and its partial visible light transmittance data is shown in Fig. 19.

Specifically, the second compound luminous layer is a green InGaN material, the cathode ohmic contact material may be one or more of Cr, Al, Ti, Ni, etc. The third compound luminous layer is InGaN blue light epitaxy, the sectional views after device preparation and electrical connection correspond to the X-axis and Y-axis of the top view, as shown in Figs. 2 to 4.

Further preferably, the bonding film of the Nth (N≥2) layer includes a stack of silicon oxide and titanium oxide, which may filter the light of the N-1 layer. For example, the N-1 layer is red light and the light emission range is 600~650nm, thus, the transmitted light may be controlled at the wavelength of 620~630nm by light filtering through the N-layer bonding film. Or, the bonding film of the Nth (N≥2) layer contains a stack of silicon oxide and aluminum oxide, which may reflect the light of the N layer, for example, when the N layer is green light, and ITO bonding is used, the reflectivity for 525nm wavelength is less than 20%. Or by introducing 150nm aluminum oxide and 180nm silicon oxide, the reflectivity for the 525nm wavelength may exceed 30%.

### Embodiment 2

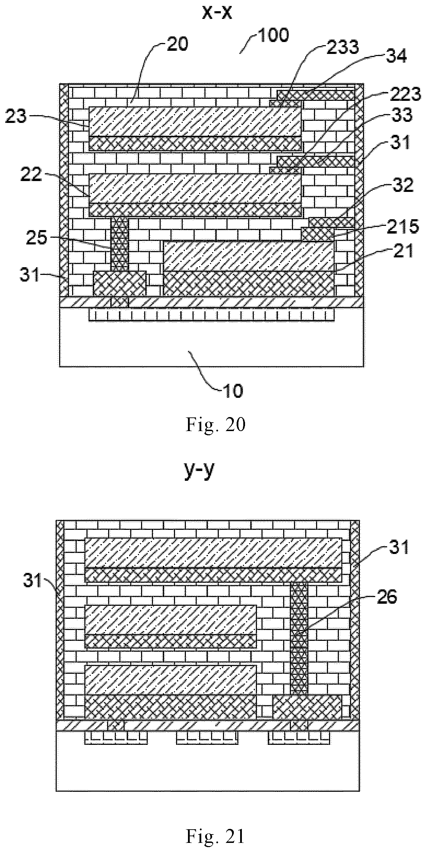

As shown in Figs. 20 and 21, this embodiment provides another pixel unit 100 for semiconductor device, the pixel unit 100 is similar to the pixel unit 100 in Embodiment 1, and the difference is that the common cathode body 31 in this embodiment is a metal frame surrounding the display unit 20 in the circumferential direction. The material of the metal frame may be metal such as aluminum and the like.

Under this difference, the first connection part 32, the second connection part 33 and the third connection part 33 connecting each device layer (21, 22, 23) and the common cathode body 31 are located in any direction of the plane of the upper surface of the current device layer, therefore, the projections of the first connecting part 32, the second connecting part 33 and the third connecting part 34 on the backplane 10 may overlap or not overlap.

Preferably, each side of the metal frame is shared by two adjacent pixel units 100, thereby further reducing the area ratio of the common cathode 30 in the pixel unit and increasing the area ratio of the luminous area.

Furthermore, the thickness of the common cathode 30 decreases from one end close to the backplane 10 to the other end.

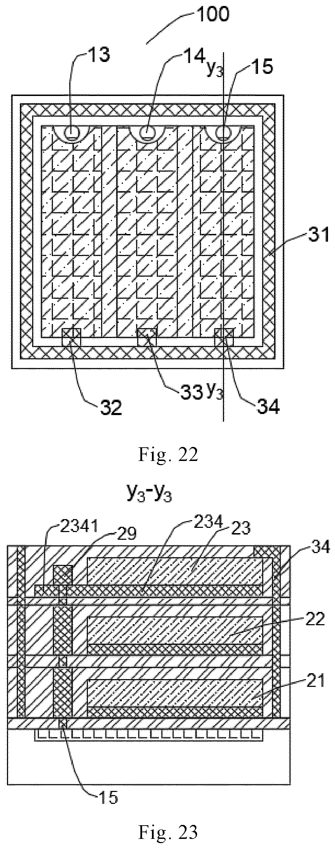

Specifically, the metal frame shrinks layer by layer as the compound semiconductor is integrated, forming an inverted bowl-shaped peripheral cathode as a constrained sidewall reflection structure, as shown in Fig. 22.

Therefore, the common cathode body 31 in this embodiment is a metal frame, which can not only realize the cathode interconnection of a single pixel, but even realize the common cathode 30 of the entire semiconductor device based on the pixel unit. Furthermore, the metal frame may be used as pixel isolation to prevent optical crosstalk between pixels, and have the function of side wall reflector.

The manufacturing method of the pixel unit in this embodiment is basically the same as the manufacturing method in Embodiment 1, and the only difference is that when preparing the common cathode 30, it is necessary to perform metal etching and filling on the periphery of the pixel to finally form a metal frame and a connection part corresponding to each layer when using the Damascus like process in this embodiment. Refers to the description in Embodiment 1 for the relevant process which will not be detailed here.

### Embodiment 3

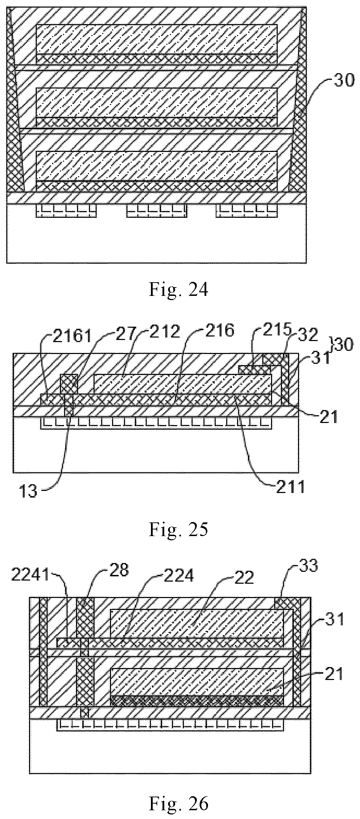

This embodiment provides another pixel unit for semiconductor device, as shown in Figs. 23 and 24, its structure is basically similar to the pixel unit structure in Embodiment 1, and the difference is:
(1) The first bonding layer 211 is made of insulation material, the second bonding layer 221 and the third bonding layer 231 are made of transparent insulation material respectively, for example, the first bonding layer 211, the second bonding layer 221, and the third bonding layer 231 are all SiO₂-SiO₂ bonding layers.

The first device layer 21 further includes a first P-type ohmic contact layer 216 disposed between the first bonding layer 211 and the first compound luminous layer, and the first P-type ohmic contact layer 216 includes a first P-type ohmic contact layer extension 2161 extending toward the common cathode 30 but not contacting the common cathode 30. The first device layer 21 further includes a first electrical connection structure 27, and one end of the first electrical connection structure 27 is connected to the corresponding first anode 13, and the free end passes through the first bonding layer 211 and is connected to the first P-type ohmic contact layer extension 2161. As a preference, the free end of the first electrical connection structure 27 does not exceed the closer side surface of the second device layer 22, and as a preference, the free end of the first electrical connection structure 27 is connected to the closer side surface of the second device layer 22, thereby achieving self-support inside the display unit 20 and improving the structural strength of the pixel unit 100 itself.

The second device layer 22 further includes a second P-type ohmic contact layer 224 disposed between the second bonding layer 221 and the second compound luminous layer 22, the second P-type ohmic contact layer 224 includes a second P-type ohmic contact layer extension 2241 extending toward the common cathode 30 but not contacting the common cathode 30.

The second device layer 22 further includes a third electrical connection structure 28, and one end of the third electrical connection structure 28 is connected to the corresponding second anode 14, and the free end passes through the first device layer 21 and is connected to the second P-type ohmic contact layer extension 2241.

The third device layer 23 further includes a fifth electrical connection structure 29 and a third P-type ohmic contact layer 234, and one end of the fifth electrical connection structure 29 is connected to the corresponding third anode 15, and its free end passes through the first device layer 21, the second device layer 22 and is connected to the third P-type ohmic contact layer extension 2341.

(2) The common cathode body 31 is a metal frame surrounding the display unit 20 in the circumferential direction.

Therefore, in the pixel unit in this embodiment, each bonding layer uses an insulation material, so each electrical connection structure needs to pass through the current and underlying bonding layers to be connected to the corresponding anode of the backplane 10, and each layer is independently connected to the metal frame to achieve a peripheral common cathode 30. Compared with Embodiment 1 or Embodiment 2, the pixel unit in this embodiment not only achieves an increase in the area ratio of the active area through the common cathode 30, and the areas of the compound luminous layers of all device layers in this embodiment are equal, and the projections on the backplane 10 overlap, there is no area loss or misalignment for avoiding internal electrical connection structures, which further improves the horizontal space utilization and pixel density, and may effectively increase the light intensity of a single pixel when multiple layers emit light at the same time.

The difference between the corresponding manufacturing method and that of Embodiment 1 is:
(1) Since the first compound semiconductor and the backplane 10 are bonded to form the first bonding layer 211 using an insulation material, bonding the pre-prepared first compound semiconductor to the backplane 10 comprises:
   plating an insulation material (such as SiO₂) on the entire surface of the backplane 10; forming a first P-type ohmic contact layer 216 on the surface of the first compound semiconductor, and plating an insulation material (such as SiO₂) on the entire surface of the first P-type ohmic contact layer 216; bonding the backplane 10 to the first compound semiconductor; removing the substrate of the first compound semiconductor.
(2) Constructing the first device layer 21 and the first common cathode 30 provided on at least one side of the first device layer 21 in the circumferential direction, comprising:
   constructing the first device layer 21 corresponding to the pattern of the backplane 10 through patterned etching and exposing the corresponding first P-type ohmic contact layer extension 2161; using patterned etching to construct at least one second through hole corresponding to at least one anode in the first P-type ohmic contact layer extension 2161; wrapping and passivating the entire surface of the first compound semiconductor; using a semiconductor patterned etching process to pattern and etch the first compound semiconductor after the entire surface passivation by silicon oxide to form an electrical channel corresponding to each anode and an electrical through hole corresponding to the first cathode ohmic contact layer 215; filling the formed electrical through hole to form a first electrical connection structure 27 corresponding to the first compound luminous layer 212 , a partial electrical connection structure corresponding to the second compound luminous layer 222, and the first common cathode 30 corresponding to the first compound luminous layer 212. The first common cathode 30 here is a part of metal fence structure. On this basis, the second device layer 22 and the third device layer 23 are repeatedly constructed, the specific structures are shown in Figs. 25 and 26.

### Embodiment 4

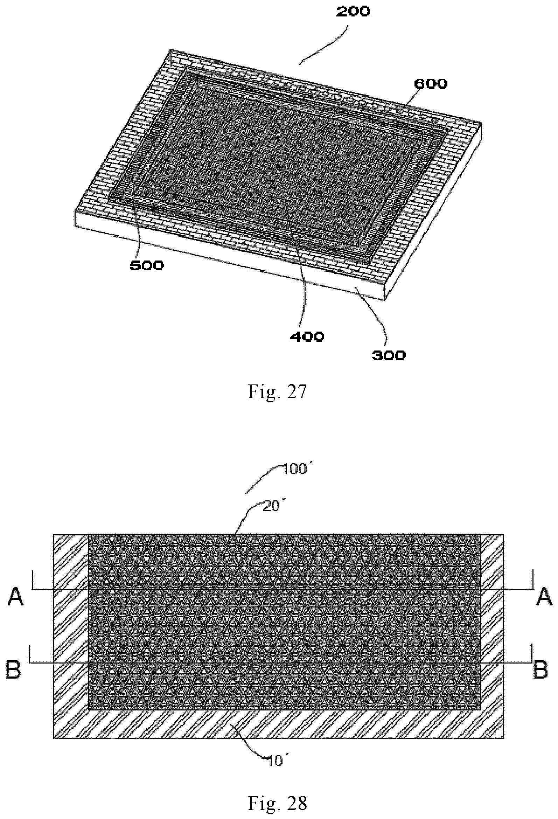

Embodiment 4 provides a micro display screen 200, as shown in Fig. 27. The micro display screen 200 includes:
a micro display screen backplane 300, which includes at least two drive circuits and input and output interfaces;
a display area 400, which is provided on the micro display screen backplane 300, and which includes at least two display units 20 as in Embodiments 1 to 3 and the corresponding common cathodes 30, in which the at least two display units 20 are arranged in an array;
a peripheral common cathode 500, which is electrically connected to the common cathode 30 of each display unit 20 respectively, so that the entire micro display screen 200 has a common cathode. It should be noted that the peripheral common cathode 500 is a metal frame structure surrounding the display area 400.
an external IO interface 600, which is located at any position on the micro display screen backplane 300.

For the specific structure and corresponding technical effects of the micro display screen in this embodiment, please refer to the relevant descriptions in Embodiments 1 to 3, and no further detailed description will be given in this embodiment.

### Embodiment 5

As shown in Figs. 28 to 31, this embodiment provides a pixel-level discrete device 100' which includes a backplane 10', at least two pads, a display unit 20', and a common cathode 30'. Among them, at least two pads specifically include N anode pads and one cathode pad 41', part of the anode pad and part of the cathode pad 41' are respectively embedded in the backplane 10', N≥1. The display unit 20' includes a first device layer 21' and a second device layer 22'. The first device layer 21' is provided on one side of the backplane 10' with at least two pads embedded therein, and the first device layer 21' is connected to the corresponding anode pad. The second device layer 22' is disposed on a surface of the first device layer 21' away from the backplane 10', the second device layer 22' is connected to the corresponding anode pad. For convenience of description, the anode pad connected to the first device layer 21' is referred to as the first anode pad 42, the anode pad connected to the first device layer 21 is referred to as the second anode pad 43. The common cathode 30' is connected to the first device layer 21', the second device layer 22' and the cathode pad 41 respectively.

Specifically, the material of the backplane 10' is one of passive substrates such as silicon, PCB, sapphire or glass, and it may also be an SOI CMOS substrate where the single-pixel circuit control switch has been completed. This embodiment uses silicon as the backplane as an example for further detailed description.

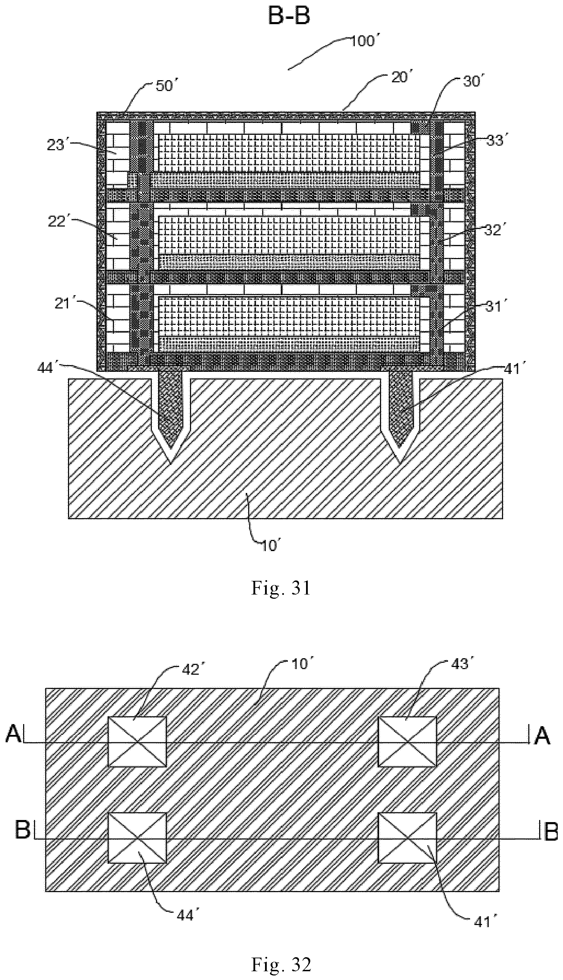

It should be noted that the pads are used to match the preset electrical connection interfaces of downstream package products, therefore this embodiment does not limit the pad structure, and in order to simplify the structure and reduce process difficulty, it is preferred that all pads have the same structure. The pad may be a solid structure or a hollow structure, as shown in Figs. 32~34.

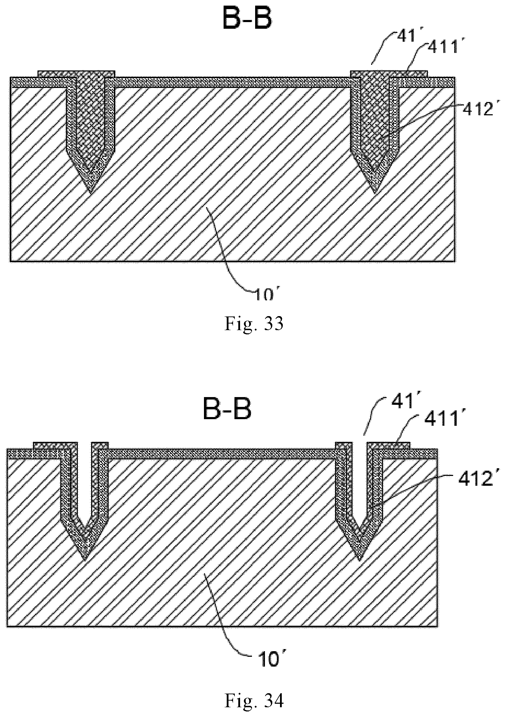

Specifically, taking the cathode pad 41' as an example, as shown in Figs. 33 and 34, it includes a first connection part 411' and a needle part 412' that are connected to each other, wherein the first connection part 411' is provided on the backplane 10' and is connected to the display unit 20', the needle part 412 is embedded in the backplane 10'. The needle part 412' may be a vertebral structure, a stepped structure, a cylindrical structure, a cuboid structure, etc. Moreover, the pad may be one or more alloys or laminates of gold, titanium, tungsten, aluminum, and platinum.

Corresponding to the above-mentioned N anode pads and one cathode pad 41', the backplane 10' is provided with at least two corresponding grooves, and the groove structure of the backplane 10' matches the corresponding pad structure.

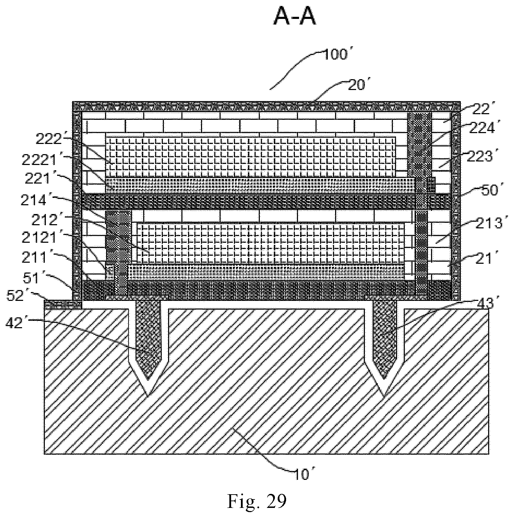

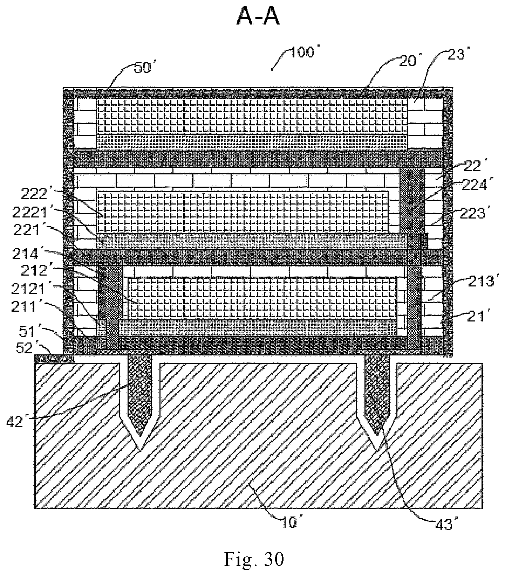

Continuing to refer to Figs. 29 and 30, the first device layer 21' includes a first bonding layer 211', a first compound luminous layer 212', a first insulation wrap layer 213' and a first electrical connection structure 214'. Among them, the first bonding layer 211' is attached to the backplane 10', the first compound luminous layer 212' is attached to the surface of the first bonding layer 211' away from the backplane 10', the first insulation wrap layer 213' wraps the first bonding layer 211' and the first compound luminous layer 212', the first electrical connection structure 214' is provided on the side of the first compound luminous layer 212'.

The material of the first bonding layer 211' may be an insulation material or a conductive material. Preferably, the first bonding layer 211' in this embodiment is made of a transparent insulation material, such as a single layer or stack of dielectric materials such as SiO₂, titanium oxide, Si₃N₄, Al₂O₃, AlN, and the like, or organic materials such as SU8, BCB, and the like. The first device layer 21' further includes a first P-type ohmic contact layer 2121' disposed between the first bonding layer 211' and the first compound luminous layer 212', and the area of the first compound luminous layer 212' is larger than the area of the first P-type ohmic contact layer 2121'. The first electrical connection structure 214' passes through the first P-type ohmic contact layer 2121' and the first bonding layer 211' in sequence and is connected to the corresponding first anode pad 42'. Among them, the first P-type ohmic contact layer 2121' is a compound semiconductor formed by high-temperature annealing Ni/Au alloy for accomplishing ohmic contact. Preferably, the area of the first P-type ohmic contact layer 2121' is larger than the area of the first compound luminous layer 212'.

Similar to the first device layer 21', the second device layer 22' includes a second bonding layer 221', a second compound luminous layer 222', a second insulation wrap layer 223' and a second electrical connection structure 224'. Among them, the second bonding layer 221' is attached to the first insulation wrap layer 312'; the second compound luminous layer 222' is attached to the surface of the second bonding layer 221' away from the first device layer 21'; the second insulation wrap layer 223' wraps the second bonding layer 221' and the second compound luminous layer 222'. The second electrical connection structure 224' is provided on the side of the first compound luminous layer 212' and the second compound luminous layer 222'.

Also preferably, the second bonding layer 221' is made of insulating material silicon nitride. On this basis, the second device layer 22' further includes a second P-type ohmic contact layer 2221' provided between the second bonding layer 221' and the second compound luminous layer 222', and the area of the second compound luminous layer 222' is larger than the area of the second P -type ohmic contact layer 2121'. The second electrical connection structure 224' sequentially passes through the second P-type ohmic contact layer 2221', the second bonding layer 221', the first insulation wrap layer 213', the first P-type ohmic contact layer 2121' and the first bonding layer 211' and is connected to the corresponding second anode pad 43.

It should be noted that when the first compound luminous layer 212' and the second compound luminous layer 222' are made of the same material, they are connected to the same anode pad, and the first anode pad 42' and the second anode pad 43 'are actually the same pad. Further, the first electrical connection structure 214' is connected to the second electrical connection structure 224' to simplify the structure. Under this structure, the pixel-level discrete device 100' realizes a redundant structure in the vertical direction by arranging the same device layer, which may achieve performance enhancement and ensure pixel yield as redundancy. When the materials of the first compound luminous layer 212' and the second compound luminous layer 222' are different, the first anode pad 42' and the second anode pad 43' are two independent pads. Therefore, the number N of anode pads is the number N of device layers. Under this structure, the pixel-level discrete device 100' may achieve full-color display, thereby achieving compression of pixel size in the horizontal direction and avoiding loss of pixel density. For convenience of description, this embodiment takes the latter as an example.

For each device layer subsequent to the second device layer 22', a light filter and a light enhancement structure may be introduced into the bonding layer, and is required to match the compound semiconductor layer of the previous layer to ensure that the wavelength of light emitted by the compound semiconductor layer of the previous layer can be transmitted, at the same time, the light of the previous layer of compound may be filtered to select a specific light wavelength band for transmission, and the bonding material of the current layer may have optical enhancement functions for itself or the subsequent layer, such as polarization, reflection, etc.

And, as shown in Figs. 30 and 31, the common cathode 30' is disposed in the first insulation wrap layer 213' and the second insulation wrap layer 223' and is connected to the cathode pad 41'. The common cathode 30' includes a first common cathode part 31', a second common cathode part 32' connected to the first common cathode part 31', and the first common cathode part 31' is connected to the cathode pad 41'. The first common cathode part 31' is provided on one side of the first compound luminous layer 212' and is connected to the first compound luminous layer 212'; the second common cathode part 32' is provided on one side of the second compound luminous layer 222' and is connected to the second compound luminous layer 222'. Therefore, the electrical connection structure and the common cathode in this embodiment are located on the side of the corresponding compound semiconductor layer, which may avoid blocking the luminous surface.

Of course, this embodiment does not limit the number of device layers, as shown in Figs. 31 and 32, on the basis of the first device layer 21' and the second device layer 22', a third device layer 23', even a fourth device layer or more may also be provided according to the needs of downstream products. For example, when the display unit 20' further includes a third device layer 23', the third device layer 23' is disposed on a surface of the second device layer 22' away from the second device layer 21', the third device layer 23 ' is connected to the corresponding anode pad, the corresponding anode pad is the third anode pad 44.

Furthermore, in order to facilitate fixation and access, the pixel-level discrete device 100 also includes a self-supporting structure 50'. The self-supporting structure 50' covers the display unit 20' and part of the backplane 10', forming a tether structure to fixedly connect the display unit 20' and the backplane 10'. Specifically, the self-supporting structure 50' includes a covering part 51' and a fixing part 52' connected in sequence, wherein the covering part 51' covers the display unit 20', the fixing part 52 is overlaid on the substrate 10'. Moreover, the display unit 20' is provided separately from the backplane 10', and at least two pads are provided separately from the backplane 10'. This separation arrangement may be achieved by pre-setting a sacrificial layer between the backplane and the at least two pads during the manufacturing process, and removing the sacrificial layer through etching or other methods after the device stacking is completed and the self-supporting structure 50' is formed. Therefore, the pixel-level discrete device 100' only needs to break the covering part 51' and the fixing part 52' through external force during transfer, which is easy to access, and the backplane of this structure may be recycled, thereby reducing costs.

It should be noted that the part of the self-supporting structure 50' covering the backplane 10' is completely attached to the backplane 10', and its edge may be in a state of being flat (as shown in Figs. 28~ 30) , exceeding or contracting inward, as compared with the corresponding edge of the backplane 10', and this embodiment does not limit this.

Corresponding to the above-mentioned pixel-level discrete device, this embodiment also provides a method for manufacturing a pixel-level discrete device, including the following steps:
S1. Constructing at least two pads partially embedded in the pre-prepared backplane, the at least two pads include N anode pads and one cathode pad, N≥1;
Before the above-mentioned step S1, it also includes:
S0. Etching the pre-prepared backplane to form at least two cavities corresponding to the at least two pads; plating a sacrificial layer on the backplane with at least two cavities, in this embodiment, the backplane uses a silicon panel.

Specifically, the sacrificial layer silicon oxynitride film is formed on the surface of the backplane through coating, thermal oxidation, wet oxidation, etc.

The pad in this embodiment is a metal pad, which may be alloys or laminates of one or more gold, titanium, tungsten, aluminum, and platinum, the preparation methods include thermal evaporation, sputtering, electroplating, or chemical plating, etc., and the pad may be solid or hollow.

S2. Stacking a first device layer and a second device layer sequentially on one side of the backplane with at least two pads inserted in the direction away from the backplane to form a display unit, the first device layer and the second device layer are respectively connected to the corresponding anode pad, and the first device layer and the second device layer are connected to the cathode pad through the formed common cathode.

Wherein, stacking a first device layer on one side of the backplane with at least two pads inserted therein specifically includes:
S21. Plating an insulation material on the entire surface of one side of the backplane with at least two pads, and plating an insulation material on the entire surface of the first P-type ohmic contact layer pre-made on the surface of the first compound semiconductor.
S22. Forming a first bonding layer by bonding the backplane to the insulation material of the first compound semiconductor; therefore, the bonding material used in this embodiment is an insulation material, specifically silicon nitride, etc.
S23. Removing and epitaxially thinning the substrate of the first compound semiconductor to expose the nitrogen contact layer of the first compound semiconductor to form a first compound luminous layer.

Of course, before step S23, the manufacturing method also includes preparing a first compound semiconductor in advance, of course, this embodiment does not limit the type of the first compound semiconductor, but the type of the compound semiconductor needs to correspond to the substrate.

For example, if the substrate is N-GaAs and the red light is AlGaInP system, the structure is as shown in Table 1. If it is an InGaN system, the structural diagram may be as shown in the aforementioned Table 2 or Table 3, and these two may be used as blue light, green light and other wavelength compound structures at the same time.

Preferably, when the first compound semiconductor is a red light compound and the second compound luminous layer is a green light compound, a red light filter is introduced into the second compound semiconductor layer and the second bonding layer, the light filter only allows red light in a specific wavelength range to pass through and avoids photoluminescence excitation of red light when thick layers of short-wavelength compounds emit light.

S24. Patterning and etching the first compound luminous layer to the first P-type ohmic contact layer. That is, the area of the etched first compound luminous layer is smaller than the first P-type ohmic contact layer, and the excess part of the first P-type ohmic contact layer is used for the construction of subsequent electrical channels.

S25. Performing wrap passivation on the entire surface of the first compound luminous layer to form a first wrap passivation layer; the first wrap passivation layer may be an inorganic dielectric material such as silicon oxide, silicon nitride, aluminum oxide and the like, or an organic dielectric material such as SU8, polyimide, and the like, this embodiment is not limited to this.

S26. Patterning and etching the first wrap passivation layer to form the corresponding first electrical connection channel and the first part of the cathode electrical connection channel;
S27. Using metal plating to form the first electrical connection structure and the first cathode part respectively, and one end of the first electrical connection structure passes through the first P-type ohmic contact layer and is connected to the corresponding anode pad, and one end of part of the first cathode is connected to the first compound semiconductor, and the other end passes through the first P-type ohmic contact layer and is connected to the cathode pad.

After completing the construction of the first device layer, a similar method is continued to construct the second device layer, and set the third device layer, etc.

Preferably, after completing the above step S2 to form the display unit, the manufacturing method further includes:
plating a dielectric material on the surface of the display unit and extending to part of the backplane surface to form a self-supporting structure; preferably, the dielectric material is silicon oxide, photoresist, etc.

Specifically, at first, patterning and etching the sacrificial layer to remove part of the sacrificial layer located on one side of the substrate, exposing part of the backplane; then plating a dielectric material on the surface of the display unit and the exposed backplane to form a self-supporting structure; finally, etching the sacrificial layer on one side of the backplane surface that is not plated with dielectric material to separate at least two pads from the backplane. The ratio of the etching rate of the sacrificial layer to the backplane is greater than 10:1, and the ratio of the etching rate of the sacrificial layer to the self-supporting structure is greater than 10:1.

It should be noted that after the dielectric material plating is completed, there is a sacrificial layer between at least part of the backplane and the display unit, and etching is performed inside the pixel discrete device at this position to etch the entire surface of the sacrificial layer, forming a gap layer between the at least two pads and the backplane to separate them. The thickness of the gap layer is determined by the thickness of the sacrificial layer. Specifically, the thickness of the sacrificial layer is 100 nm to 1000 nm, preferably 300 to 500 nm.

To sum up, this embodiment achieves compression of pixel size in the horizontal direction by arranging at least two vertically stacked device layers on the backplane, avoids the loss of pixel density, and reduces the number of pixels arranged, reduces the number of chips transferred during mass transfer so that improves accuracy and yield;

In addition, each vertically stacked device layer in the display unit in this application uses a common cathode to reduce the area ratio of the cathode in the discrete pixel device, increase the area ratio of the luminous area, reduce the impact of the size effect, and at the same time increase the stacking number of device layers in the vertical direction or form redundant circuits.

In addition, the pixel discrete device of this application is connected to an external circuit based on at least two pads, when the discrete device is packaged to the target backplane for electrical connection, metal welding such as eutectic may be avoided to avoid affecting the performance of the discrete device itself and simplify processes.

In addition, the pixel discrete device achieves structural stability by providing a self-supporting structure under the setting that the display unit and backplane are separated, and is convenient for later use, more importantly, the backplane may be recycled under this structure, thereby reducing cost.

In addition, in this embodiment, the electrical connection structure and the common cathode are located on the side of the corresponding compound semiconductor layer, which may avoid blocking the luminous surface.

### Embodiment 6

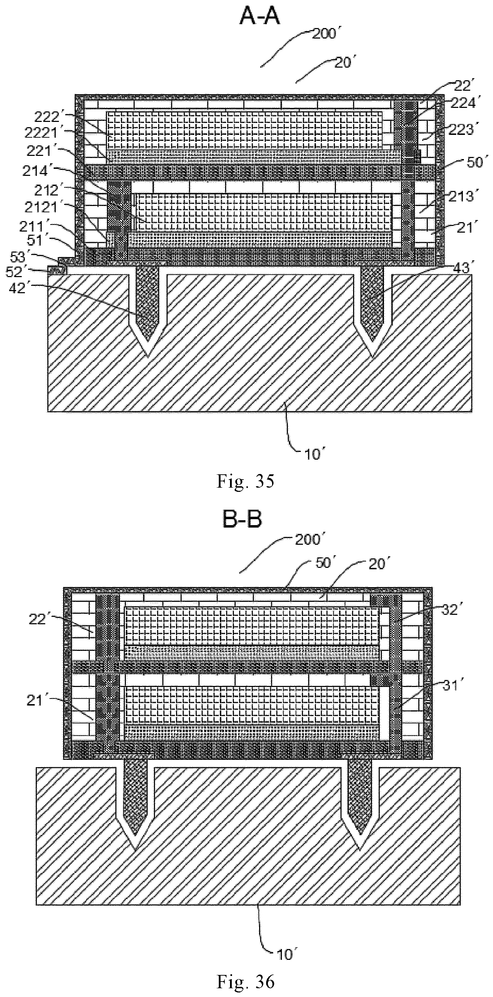

As shown in Figs. 35 to 38, this embodiment further provides a pixel-level discrete device 200 and a manufacturing method thereof. The structure and manufacturing method of the pixel-level discrete device 200 are basically the same as those of the pixel-level discrete device 100 in Embodiment 1, and the only difference lies in the self-supporting structure 50.

Specifically, the self-supporting structure 50 in this embodiment includes a covering part 51 covering the display unit 20, a fixing part 52 overlaid on the substrate 10, a second connection part 53 which has one end connected to the covering part 51 and the other end connected to the fixing part 52, and the second connection part 53 is provided separately from the substrate 10. Preferably, the second connection part 53 is provided above the fixing part 52, and the second connection part 53 and the fixing part 52 form a ladder structure extending from top to bottom. Compared with Embodiment 1, the self-supporting structure 50 in this embodiment is added with a second connection part 53, thereby ensuring the fixation effect of the self-supporting structure 50 on the device layer 20 and improving the operational convenience when the covering part 51 and the fixing part 52 break under the action of external force during transfer, more importantly, the breaking position is located at the second connecting part 53 rather than the covering part 51 or the fixing part 52 to avoid damaging the substrate 10 or device layer 20.

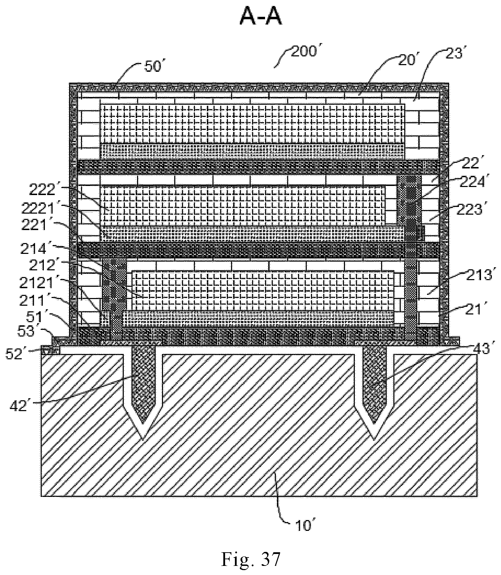

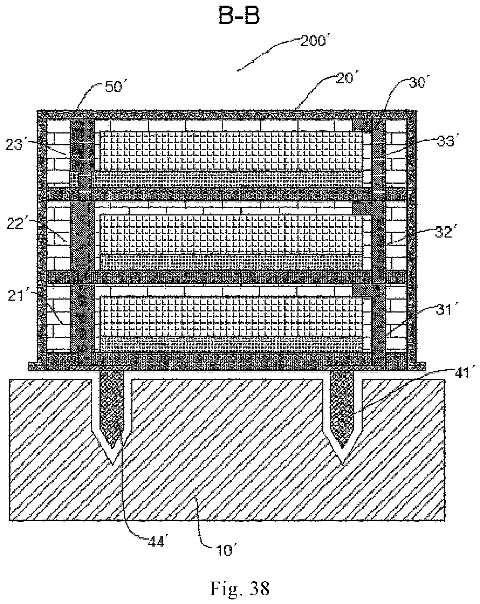

Preferably, as shown in Figs. 37 and 38, in the portion where the fixing part 52 and the second connection part 53 are not provided between the display unit 20 and the substrate 10, the self-supporting structure 50 in this embodiment further includes an extension structure connected at an angle to the covering part 51. The arrangement of the extension structure may prevent excessive deviation from exposing the side walls of the display unit 30 that need to be protected during the etching process.

Furthermore, when manufacturing the pixel-level discrete device 200 in this embodiment, an improvement compared to Embodiment 1 is: the step of plating a dielectric material on the surface of the display unit and extending it to part of the backplane surface to form a self-supporting structure.

Specifically, after forming the display unit, at first, patterning and etching the sacrificial layer to remove at least one side of the sacrificial layer that is beyond a preset distance away from the display unit, exposing part of the substrate; then, plating dielectric materials on the surface of the display unit, the surface of the sacrificial layer and the surface of the exposed backplane on one side to form a self-supporting structure; finally, etching the sacrificial layer on one side that is not plated with dielectric material to separate at least two pads from the backplane.

All the above optional technical solutions may be combined in any way to form optional embodiments of the present application, that is, any multiple embodiments may be combined to meet the needs of different application scenarios, which are all within the protection scope of the present application, and will not be repeated one by one.

It should be noted that the above are only preferred embodiments of the present application and are not intended to limit the present application, any modifications, equivalent substitutions, improvements, etc. made within the spirit and principles of the present application shall include within the protection scope of this application.

## Claims

1. A pixel unit for semiconductor device, including:
a backplane;
a display unit, the display unit being provided on the backplane, the display unit including a first device layer and a second device layer that are vertically stacked in sequence, the second device layer being provided on a surface of the first device layer away from the backplane, and the first device layer and the second device layer being respectively connected to the backplane;
and
a common cathode, the common cathode being connected to each device layer in the display unit respectively.

2. The pixel unit according to claim 1, wherein the common cathode includes a common cathode body, a first connection part and a second connection part respectively connected to the common cathode body, and the first connection part is connected to the first device layer, and the second connection part is connected to the second device layer.

3. The pixel unit according to claim 2, wherein the backplane is provided with a drive circuit, the drive circuit includes at least two anodes, any one of the anodes is connected to a corresponding device layer, the at least two anodes are located within the projection range of the display unit on the backplane;
the common cathode is connected to the external cathode.

4. The pixel unit according to claim 2, wherein the first device layer includes a first bonding layer, a first compound luminous layer and an insulation wrap layer arranged in sequence, the first compound luminous layer is attached to a surface of the first bonding layer away from the backplane, and the insulation wrap layer wraps the first bonding layer and the first compound luminous layer.

5. The pixel unit according to claim 4, wherein the first bonding layer is made of conductive material, and a first insulation layer is provided between the backplane and the first bonding layer;
the first insulation layer is provided with at least one first through hole, and the first bonding layer is connected to the corresponding first anode through the first through hole.

6. The pixel unit according to claim 5, wherein the common cathode is embedded inside the display unit; or,
the common cathode body is a metal frame surrounding the display unit in a circumferential direction, and the first connection part and the second connection part are embedded inside the display unit.

7. The pixel unit according to claim 4, wherein the first bonding layer is made of insulation material;
the first device layer further includes a first P-type ohmic contact layer provided between the first bonding layer and the first compound luminous layer, the first P-type ohmic contact layer includes a first P-type ohmic contact layer extension extending toward the common cathode but not contacting the common cathode;
the first device layer further includes a first electrical connection structure, one end of the first electrical connection structure is connected to the corresponding first anode, and the free end passes through the first bonding layer and is connected to the first P-type ohmic contact layer extension.

8. The pixel unit according to claim 7, wherein the common cathode body is a metal frame surrounding the display unit in a circumferential direction.

9. The pixel unit according to claim 5, wherein the first connection part is connected to the first compound luminous layer.

10. The pixel unit according to claim 5, wherein the first device layer further includes a first cathode ohmic contact layer, the first cathode ohmic contact layer is attached to a surface of the first compound luminous layer away from the first bonding layer, and the first connection part is connected to the first cathode ohmic contact layer.

11. The pixel unit according to claims 4 to 10, wherein the second device layer includes a second bonding layer, a second compound luminous layer and an insulation wrap layer; the second compound luminous layer is attached to a surface of the second bonding layer away from the first device layer, the insulation wrap layer wraps the first bonding layer and the first compound luminous layer.

12. The pixel unit according to claim 11, wherein the second bonding layer is made of transparent conductive material or transparent semiconductor material;
the second device layer also includes a second electrical connection structure, one end of the second electrical connection structure is connected to the second anode of the backplane, and the other end passes through the first device layer and is connected to the second bonding layer.

13. The pixel unit according to claim 12, wherein the second electrical connection structure includes a first metal pillar, one end of the first metal pillar is connected to the corresponding second anode, the other end passes through the first device layer and is connected to the second bonding layer; or,
the second electrical connection structure includes a first connection layer and a first metal pillar connected to the first connection layer, the first connection layer passes through the first insulation layer and is connected to the corresponding second anode, the first metal pillar is connected to the second bonding layer.

14. The pixel unit according to claim 11, wherein the second bonding layer is made of transparent insulation material;
the second device layer includes a second P-type ohmic contact layer provided between the second bonding layer and the second compound luminous layer, and the second P-type ohmic contact layer includes a second P-type ohmic contact layer extension extending toward the common cathode but not contacting the common cathode;
the second device layer further includes a third electrical connection structure, one end of the third electrical connection structure is connected to the corresponding third anode, and the free end passes through the first device layer and is connected to the second P-type ohmic layer extension.

15. The pixel unit according to claim 11, wherein the first compound luminous layer and the second compound luminous layer use the same compound luminous material, the first device layer and the second device layer are connected to the same anode, and the first device layer and the second device layer are arranged in series or parallel.

16. The pixel unit according to any one of claims 2 to 15, wherein the display unit further includes a third device layer stacked on a side of the second device layer away from the first device layer;
the third device layer is connected to the third anode of the backplane;
the common cathode further includes a third connection part connected to the common cathode body, the third connection portion is connected to the third device layer.

17. The pixel unit according to claim 16, wherein the thickness of the common cathode decreases from one end close to the backplane to the other end.

18. The pixel unit according to claim 16, wherein the pixel unit further comprises an optical enhancement structure, the optical enhancement structure is stacked on a side of the display unit away from the backplane.

19. The pixel unit according to claim 1, wherein the backplane is provided with N anode pads and one cathode pad, part of the anode pads and part of the cathode pad are respectively embedded in the backplane, N≥1; any one of the anode pads is connected to a corresponding device layer, the cathode pad is connected to each device layer through the common cathode.

20. The pixel unit according to claim 19, wherein the display unit is provided separately from the backplane, and the at least two pads are provided separately from the backplane;
the pixel unit further includes a self-supporting structure, the self-supporting structure covers the device body and part of the backplane.

21. The pixel unit according to claim 20, wherein the self-supporting structure includes a covering part and a fixing part connected in sequence, the covering part covers the display unit, the fixing part is overlaid on the substrate; or,
the self-supporting structure includes a covering part, a second connection part and a fixing part connected in sequence, the covering part covers the display unit body, the fixing part is overlaid on the substrate, the connection part is provided separately from the substrate.

22. A method of manufacturing a pixel unit for semiconductor device, including:
preparing a backplane, wherein the backplane is provided with a drive circuit, and the drive circuit is provided with at least one anode;and
forming a display unit and a corresponding common cathode, bonding the pre-prepared first compound semiconductor to the backplane, constructing a first device layer and a first common cathode on at least one side corresponding to the first device layer; bonding the pre-prepared second compound semiconductor to the surface of the side of the first device layer away from the backplane, and constructing a second device layer and a second common cathode on at least one side of the second device layer in the circumferential direction of the second device layer, connecting the second device layer to the corresponding anode and the second common cathode of the backplane respectively, and the second common cathode and the first common cathode are connected end to end to form a common cathode.

23. The manufacturing method according to claim 22, wherein a conductive material is used when bonding the first compound semiconductor to the backplane, wherein bonding the pre-prepared first compound semiconductor to the backplane includes:
plating insulation material on the entire surface of the backplane provided with at least two anodes, and opening at least two first through holes corresponding to the at least two anodes;
plating conductive material on the entire surface of the backplane after plating the insulation layer to form a backplane plated with bonding material;
plating conductive material on the entire surface of the first compound semiconductor to form a first compound semiconductor plated with bonding material;
bonding the backplane and the first compound semiconductor plated with bonding material, respectively;
removing the substrate of the first compound semiconductor.

24. The manufacturing method according to claim 22, wherein constructing the first device layer and the first common cathode provided on at least one side of the first device layer in the circumferential direction, includes:
performing pattern exposure and etching on the first compound semiconductor to construct a first device layer corresponding to the backplane pattern and reserving at least one first through hole corresponding to the remaining anode;
providing a first cathode ohmic contact layer on a surface of the first device layer away from the first bonding layer;
using a semiconductor patterned coating to construct at least one metal pillar for subsequent device layers except the first device layer in the at least one first through hole;
performing entire surface wrap passivation on the first compound semiconductor;
using a semiconductor patterned etching process to pattern and etch the first compound semiconductor after the entire surface passivation by silicon oxide to form electrical through holes corresponding to the remaining anode and the first cathode ohmic contact layer;
filling the formed electrical through holes to form electrical connections to the remaining anodes and to form a first common cathode.

25. The manufacturing method according to claim 22, wherein an insulation material is used to bond the first compound semiconductor to the backplane to form a first bonding layer, wherein bonding the pre-prepared first compound semiconductor to the backplane, includes:
plating insulation material on the entire surface of the backplane;
forming a first P-type ohmic contact layer on the surface of the first compound semiconductor, and plating insulation material on the entire surface of the first P-type ohmic contact layer;
bonding the backplane to the first compound semiconductor;
removing the substrate of the first compound semiconductor.

26. The manufacturing method according to claim 25, wherein constructing the first device layer and the first common cathode provided on at least one side of the first device layer in the circumferential direction, includes:
constructing the first device layer corresponding to the backplane pattern through patterned etching and exposing the corresponding first P-type ohmic contact layer extension;
using patterned etching to construct at least one second through hole corresponding to at least one of the anodes in the first P-type ohmic contact layer extension;
performing entire surface wrap passivation on the first compound semiconductor;
using a semiconductor patterned etching process to pattern and etch the first compound semiconductor after the entire surface passivation by silicon oxide to form an electrical channel corresponding to each anode and an electrical through hole corresponding to the first cathode ohmic contact layer;
filling the formed electrical through hole to form a first electrical connection structure corresponding to the first compound luminous layer , a partial electrical connection structure corresponding to the second compound luminous layer, and a first common cathode corresponding to the first compound luminous layer.

27. The manufacturing method according to any one of claims 222 to 26, wherein after completing the second device layer and the second common cathode provided on at least one side of the second device layer in the circumferential direction, forming the display unit and the common cathode further includes:
bonding a pre-prepared third compound semiconductor to the surface of the second device layer away from the first device layer, and constructing a third device layer and a third common cathode disposed on at least one side of the third device layer in the circumferential direction.

28. A method of manufacturing a pixel unit for semiconductor device, including:
constructing at least two pads partially embedded in a pre-prepared backplane, the at least two pads include N anode pads and one cathode pad, N≥1;and
sequentially stacking a first device layer and a second device layer on one side of the backplane where the at least two pads are inserted in a direction away from the backplane to form a display unit, wherein the first device layer and the second device layer are connected to the corresponding anode pad, respectively, and the first device layer and the second device layer is connected to the cathode pad through the formed common cathode.

29. The manufacturing method according to claim 28, wherein before inserting at least two pads on the pre-prepared backplane, the method further includes:
etching to form at least two cavities corresponding to at least two pads on the pre-prepared backplane;
plating a sacrificial layer on the backplane with at least two cavities.

30. The manufacturing method according to claim 29, wherein after sequentially stacking a first device layer and a second device layer on one side of the backplane where the at least two pads are inserted in a direction away from the backplane to form a display unit, the method further includes:
plating a dielectric material on the surface of the display unit and extending to part of the surface of the backplane to form a self-supporting structure;
etching the sacrificial layer on one surface of the backplane that is not plated with the dielectric material to separate the at least two pads from the backplane; wherein the ratio of the etching rate of the sacrificial layer to the backplane is greater than 10:1, and the ratio of the etching rate of the sacrificial layer to the self-supporting structure is greater than 10:1.

31. A micro display screen, including:
a micro display screen backplane, the micro display screen backplane including at least two drive circuits, input interfaces and output interfaces;
a display area, the display area being provided on the micro display screen backplane, and the display area including at least two display units included in the pixel unit for semiconductor device according to any one of claims 1 to 19 or the pixel unit manufactured by the manufacturing method according to any one of claims 22 to 27;
a peripheral common cathode, the peripheral common cathode being electrically connected to the common cathode of each display unit, respectively.

32. A discrete device, including:
a discrete device backplane, the discrete device backplane including at least two anode pads and at least one cathode pad;
a device body, the device body being provided on the discrete device backplane, and the device body includes at least two display units included in the pixel unit for semiconductor device according to any one of claims 1 and 19 to 21 or the pixel unit manufactured by the manufacturing method according to any one of claims 28 to 30.
